(19) Europäisches Patentamt
European Patent Office
Office européen des brevets

(11) **EP 4 250 566 B1**

(12) **EUROPÄISCHE PATENTSCHRIFT**

(45) Veröffentlichungstag und Bekanntmachung des Hinweises auf die Patenterteilung:
**31.07.2024 Patentblatt 2024/31**

(21) Anmeldenummer: **23184732.8**

(22) Anmeldetag: **30.03.2022**

(51) Internationale Patentklassifikation (IPC):
**H03K 17/78** (2006.01) **H03K 17/10** (2006.01)
**H03K 17/0414** (2006.01)

(52) Gemeinsame Patentklassifikation (CPC):
**H03K 17/107; H03K 17/0414; H03K 17/78;**
H03K 2217/0036

(54) **HOCHLEISTUNGSSCHALTMODUL ZUR DIREKTEN PULSENERGIESPEISUNG EINES VERBRAUCHERS**

HIGH POWER SWITCHING MODULE FOR DIRECT PULSE POWER SUPPLY OF A CONSUMER

MODULE DE COMMUTATION HAUTE PERFORMANCE POUR L'ALIMENTATION DIRECTE EN ÉNERGIE PULSÉE D'UN CONSOMMATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.06.2021 DE 102021115470**

(43) Veröffentlichungstag der Anmeldung:
**27.09.2023 Patentblatt 2023/39**

(62) Dokumentnummer(n) der früheren Anmeldung(en) nach Art. 76 EPÜ:
**22165549.1 / 4 106 196**

(73) Patentinhaber: **Spree Hybrid & Kommunikationstechnik GmbH 12681 Berlin (DE)**

(72) Erfinder:
• **Müller, Sebastian**
  **16356 Ahrensfelde (DE)**
• **Kovalev, Igor**
  **10557 Berlin (DE)**
• **Segsa, Karl-Heinz**
  **12555 Berlin (DE)**
• **Schurack, Johannes**
  **12589 Berlin (DE)**

(74) Vertreter: **Müller, Wolfram Hubertus Patentanwalt Teltower Damm 15 14169 Berlin (DE)**

(56) Entgegenhaltungen:
EP-A2- 0 967 743     WO-A2-2011/095212
GB-A- 2 351 621     US-A- 5 061 859

**Beschreibung**

Die Erfindung betrifft ein Hochleistungsschaltmodul zur direkten Pulsenergiespeisung eines Verbrauchers gemäß dem Oberbegriff des Patentanspruchs 1.

In vielen Systemen der Lasertechnik, Ionenquellen und Ionenoptiken müssen mit hohen Spannungen Laststrecken mit Hochleistungsschaltmodulen direkt geschaltet werden. Die Last von diesen Hochleistungsschaltmodulen muss in sehr kurzer Zeit, insbesondere unter 40ns, in einen niederohmigen Zustand gebracht werden, um schnell und effizient hohe Ströme einspeisen oder Kapazitäten direkt umladen zu können. Beispiele sind der Gasentladungskanal eines transversal elektrisch angeregten Gasentladungslasers, beispielsweise $CO_2$-Lasers, zur Erzeugung von Lichtpulsen geringer Breite, die Ansteuerung von Pockels-Zellen zur Lichtmodulation und Einrichtungen zur Steuerung von Ionen-Flugbahnen in Time-of-Flight-Spektrometern. Die Schaltvorgänge müssen sehr schnell und hochpräzise ablaufen, es müssen Folgefrequenzen bis zu 10 kHz und mehr ermöglicht werden.

Es besteht somit ein Bedarf an einem robusten, langlebigen Hochleistungsschaltmodul, das ein schnelles Einspeisen von Strömen oder Laden und Entladen von Kapazitäten und Induktivitäten ermöglicht.

Aus der WO 2007/134589 A3 ist ein Hochleistungsschaltmodul zur direkten Pulsenergiespeisung eines Verbrauchers mit in Reihe geschalteten Schaltstufen bekannt, die jeweils einen Halbleiterschalter mit Anoden-, Kathoden und Steueranschluss und ein auf den Halbleiterschalter einwirkendes, mit Hilfsenergie von einem Pulstreiber versorgtes Treibernetzwerk zur Schaltbeeinflussung des Halbleiterschalters aufweisen. Für eine individuelle Einstellbarkeit der zeitlichen Lage des Arbeitspunkts in jeder Schaltstufe weist das Treibernetzwerk ein einstellbares Verzögerungselement auf, mit dem eine schaltstufenindividuelle Offsetspannung am Halbleiterschalter zur variablen Einstellung seiner Ein- und Ausschaltpunkte eingestellt werden kann. Nachteilig an der beschriebenen Lösung ist, dass sämtliche Halbleiterschalter in Abhängigkeit vom jeweils langsamsten Halbleiterschalter in ihrer Einschaltdauer gezielt verzögert werden. Die schnelleren Halbleiterschalter fangen an ihre Gate-Spannung von einem Offset zu ändern.

Ein weiteres Hochleistungsschaltmodul aus dem Stand der Technik ist aus WO 2011/095212 A2 bekannt.

Der vorliegenden Erfindung liegt die Aufgabe zugrunde, ein Hochleistungsschaltmodul zur direkten Pulsenergiespeisung eines Verbrauchers sowie ein Verfahren zur Verfügung zu stellen, die Verbesserungen im Hinblick auf die Effektivität des Hochleistungsschaltmoduls und/oder die Schaltsynchronität der einzelnen Schaltstufen bereitstellen.

Diese Aufgabe wird durch ein Hochleistungsschaltmodul mit den Merkmalen des Anspruchs 1 gelöst. Ausgestaltungen der Erfindung sind in den abhängigen Ansprüchen angegeben.

Die vorliegende Erfindung stellt in einem ersten Erfindungsaspekt ein Hochleistungsschaltmodul zur direkten Pulsenergiespeisung eines Verbrauchers mit einer Mehrzahl in Reihe geschalteter Schaltstufen bereit, bei dem jede Schaltstufe aufweist:

- einen Halbleiterschalter (Schaltelement) mit Kollektoranschluss, Emitteranschluss und Steueranschluss, der abhängig von der am Steueranschluss anliegenden Spannung einen eingeschalteten Zustand, in dem zwischen dem Kollektoranschluss und dem Emitteranschluss ein Strom fließt, und einen ausgeschalteten Zustand, in dem zwischen dem Kollektoranschluss und dem Emitteranschluss kein Strom fließt, aufweist,
- eine auf den Halbleiterschalter einwirkende Treiberbaugruppe, wobei die Treiberbaugruppe zwei Schalter zur Steuerung des Steueranschlusses des Halbleiterschalters sowie einen Energiespeicher aufweist, der Energie für das Einschalten des Halbleiterschalters bereitstellt, und
- ein optisches Triggernetzwerk wie es in Anspruch 1 definiert ist.

Es kann vorgesehen sein, dass jede Schaltstufe Koppelglied und einen Energiezwischenspeicher aufweist, wobei

- das Koppelglied einen Primärkreis, der die Symmetrisierkapazität und den Halbleiterschalter umfasst, mit einem Sekundärkreis, der den Energiezwischenspeicher umfasst, koppelt,
- das Koppelglied dazu vorgesehen und ausgebildet ist, während der Einschaltphase des Halbleiterschalters Energie der Symmetrisierkapazität zu erhalten und diese Energie an den Energiezwischenspeicher abzugeben, und
- der Energiezwischenspeicher dazu vorgesehen und ausgebildet ist, die erhaltene Energie an den Energiespeicher der Treiberbaugruppe abzugeben, wenn der Halbleiterschalter sich im ausgeschalteten Zustand befindet (d.h. sperrt).

Die aufgeladene Symmetrisierkapazität wird somit beim Einschalten des Halbleiterschalters im Primärkreis entladen. Der Sekundärkreis enthält den Energiezwischenspeicher, der beim Einschalten des Halbleiterschalters durch induktive oder kapazitive Koppelelemente zusätzlich geladen wird. Dabei erhält der Energiezwischenspeicher seine Energie während der Einschaltphase des Halbleiterschalters und erhält der Energiespeicher der Treiberbaugruppe seine Energie während der Sperrphase des Halbleiters.

Ein mit diesen Merkmalen verbundener, nicht zur Erfindung gehörender Aspekt beruht damit auf dem Gedanken, einen Energiezwischenspeicher der jeweiligen Treiberbaugruppe zusätzlich durch Energie der Symmetrisierkapazität aufzuladen und damit die Energie der Symmetrisierkapazität einer zusätzlichen Nutzung zuzuführen. Dies erfolgt über das kapazitive oder induktive Koppelelement. Dieser Erfindungsaspekt sieht somit vor, die in der Symmetrisierkapazität gespeicherte Energie nicht nutzlos als Wärme dissipieren zu lassen, sondern teilweise an den Energiezwischenspeicher zu übertragen. Auf diese Weise kann diese Energie nachgenutzt und für den nächsten Schaltvorgang mittels Energiespeicher der Treiberbaugruppe wiederverwendet werden. Eine Verringerung der Verluste im Schaltelement und eine Reduzierung der Nachladeverluste wird erreicht. Dies ist von besonderem Vorteil bei hohen Schaltfrequenzen, da diese Lösung die Zeitdauer bis zum Aufladen des Energiespeichers in der Ausschaltphase verkürzt.

Allgemein gilt, dass Symmetrisierkapazitäten der Optimierung der Schaltsynchronität der Schaltstufen eines Hochleistungsschaltmoduls dienen. Sie sorgen für eine dynamische Spannungsaufteilung in der Schaltphase und speisen die Halbleiterschalter in den sicher geschalteten Zustand.

Eine Aufladung der Energiezwischenspeicher der Treiberbaugruppen erfolgt dabei "zusätzlich" in dem Sinne, als der Energiezwischenspeicher der jeweiligen Treiberbaugruppe zusätzlich über einen an sich bekannten ohmschen Symmetriewiderstand aufgeladen wird. Ein solcher ohmscher Symmetriewiderstand erfüllt dabei zwei Aufgaben. Zum einen sorgt er statisch dafür, dass eine Gesamthochspannung UH am Hochleistungsschaltmodul sich symmetrisch über die einzelnen Schaltstufen aufteilt, wobei für die Spannung Un einer Schaltstufe gilt: Un=UH/n, wenn n gleich der Anzahl der Schaltstufen ist. Zum anderen ruft die durch den Symmetriewiderstand an einer Schaltstufe erzeugte Spannung Un einen Symmetriestrom hervor, wobei ein Teil des Symmetriestroms den Energiezwischenspeicher - unabhängig von der Bereitstellung von Energie durch die Symmetrisierkapazität und das induktive oder kapazitive Koppelelement - auflädt.

Dabei verhält es sich insbesondere so, dass über den Symmetriestrom eine Initialladung für den ersten Schaltvorgang auf den Energiezwischenspeicher fließt. Es fließen beim zyklischen Einschalten des Halbleiterschalters zusätzlich Ströme und Ladungen auf den jeweiligen Energiezwischenspeicher der Treiberstufe. Dadurch wird eine effizientere, folgefrequenzunabhängige Stromversorgung der Treiberbaugruppe sichergestellt.

Bei dem Koppelglied handelt es sich um ein induktives oder kapazitives Koppelglied.

Eine Ausführungsvariante, die nicht zur Erfindung gehört, sieht dementsprechend vor, dass das Koppelglied einen Transformator umfasst, der eine Primärwicklung im Primärkreis und eine Sekundärwicklung im Sekundärkreis aufweist, wobei der Sekundärkreis den Energiezwischenspeicher der Treiberbaugruppe zusätzlich auflädt. Diese Ausführungsvariante sieht somit eine induktive Kopplung zwischen Primärkreis und Sekundärkreis bzw. der Symmetrisierkapazität und dem Energiezwischenspeicher für die Treiberbaugruppe vor, die über einen Transformator realisiert wird. Der beim Einschalten der Leistungsstufe im Primärkreis auftretende Stromfluss zwischen Symmetrisierkapazität und Leistungshalbleiterschalter induziert sekundärseitig einen Strom zur Aufladung des Energiezwischenspeichers der jeweiligen Treiberbaugruppe.

Abhängig vom gewählten Wickelsinn der Sekundärwicklung können beispielsweise positive oder negative Stromversorgungen nachgeladen werden. Der Energiezwischenspeicher wird dabei während der Einschaltphase des Halbleiterschalters durch die Energie der Symmetrisierkapazität aufgeladen.

Der Transformator ist in einem nicht zur Erfindung gehörenden Ausführungsbeispiel als Printtransformator und dabei derart ausgebildet, dass der Primärkreis durch eine singuläre Schlaufe einer Leitebene gebildet ist und der Sekundärkreis des Transformators durch eine Sekundärwicklung auf einem Wickelkörper gebildet ist, der in die Schlaufe eingeführt ist. Die Leitebene, die die Schlaufe bildet, kann dabei durch eine breite/flache Leitung (beispielsweise Emitterfläche) gebildet sein, die durch die Schlaufe eine Modifikation erfährt. Die Leitebene ist die Primärseite des Printtransformators. Infolge dieses Stromes bildet sich ein Magnetfeld aus. Die Sekundärseite ist ein Wickelkörper mit der Sekundärwicklung, der in diese Schlaufe reingeführt wird. So sind beide Stromkreise (primärer und sekundärer Kreis) magnetisch miteinander gekoppelt.

Gemäß einer weiteren nicht zur Erfindung gehörenden Variante erfolgt die Kopplung zwischen der Symmetrisierkapazität und dem Energiezwischenspeicher nicht induktiv, sondern kapazitiv. Für diesen Fall ist vorgesehen, dass das Koppelglied durch kapazitive Elemente mit der Symmetrisierkapazität verbunden ist.

Eine Ausführungsvariante hierzu sieht vor, dass das Koppelglied eine Koppelkapazität, die in Reihe mit der Symmetrisierkapazität geschaltet ist, sowie eine parallel zu der Koppelkapazität geschaltete Spule aufweist, wobei die Koppelkapazität über eine Diode Energie an den Energiespeicher der Treiberbaugruppe überträgt. Dabei ist die Koppelkapazität im Sperrzustand über die Spule kurzgeschlossen ist. Im eingeschalteten Zustand kann eine weitere Hilfskapazität parallel zu der ersten Hilfskapazität geschaltet sein. Die Koppelkapazität oder eine solche weitere Hilfskapazität speist die ausgekoppelte Energie in den Energiezwischenspeicher ein, wodurch die Energie für den nächsten Schaltvorgang bereitgestellt wird.

Der Energiezwischenspeicher im Sekundärkreis wird beispielsweise durch ein oder mehrere kapazitive Elemente gebildet.

Eine weitere Ausgestaltung sieht vor, dass im Sekundärkreis ein Energietransfer-Schalter vorgesehen ist, der dafür sorgt, dass der Energiezwischenspeicher im Sekundärkreis seine Energie an den Energiespeicher der Treiberbaugruppe abgibt, wenn der Halbleiterschalter sperrt. Dieser Schalter ist geschlossen (d.h. erlaubt einen Stromfluss - "ein"), wenn der Halbleiterschalter sperrt und öffnet (d.h. sperrt den Stromfluss - "aus") in der Einschaltphase des Halbleiterschalters. Damit ist - wenn der Energietransfer-Schalter geöffnet ist - ein Energietransfer vom Energiezwischenspeicher in den Energiespeicher der Treiberbaugruppe in der Einschaltphase des Halbleiterschalters, wenn der Energiezwischenspeicher aufgeladen wird, gesperrt. Dagegen kann - wenn der Energietransfer-Schalter geschlossen ist - die zwischengespeicherte Energie vom Energiezwischenspeicher auf den Energiespeicher der Treiberbaugruppe transferiert werden, wenn der Halbleiterschalter sperrt.

Dabei kann vorgesehen sein, dass der Energietransfer-Schalter mit dem gleichen Befehl bzw. Signal zum Öffnen gebracht wird, mit dem der Halbleiterschalter eingeschaltet wird. Ein solcher Befehl kann durch das gleiche Steuersignal bereitgestellt werden, das der eine der Schalter zur Steuerung des Steueranschlusses des Halbleiterschalters erhält. Das Steuersignal zum Öffnen des Halbleiterschalters bewirkt das Öffnen des Energietransfer-Schalters. Das Steuersignal zum Schließen des Halbleiterschalters bewirkt dagegen das Überführen des Energietransfer-Schalters in den geschlossenen Zustand, so dass der Energiespeicher aufgeladen werden kann. Dabei ist der Energietransfer-Schalter ein "normally closed" Schalter, der im Normalzustand geschlossen ist. Die Steuerung des Energietransfer-Schalters über die Schaltbefehle für den Halbleiterschalter ist jedoch nur beispielhaft zu verstehen. Alternativ kann der im Normalzustand geschlossene Energietransfer-Schalter beispielsweise induktiv angesteuert werden.

Der Sekundärkreis umfasst eine Diode. Die Diode definiert den Auflageweg des Energiezwischenspeichers und verhindert den Rückfluss der umgeladenen Energie. Aus dem gleichen Grund gibt es auch eine Diode im ohmschen Symmetriestromkreis für die Initialladung.

Gemäß einem weiteren nicht zur Erfindung gehörenden Ausführungsbeispiel umfasst die Treiberbaugruppe des Weiteren ein thermisches Anpassnetzwerk, welches die Steuerspannung des Halbleiterschalters temperaturabhängig beeinflusst. Die erforderliche Steuerspannung am Steueranschluss des Halbleiterschalters, die den Einschaltvorgang auslöst, ist von der Temperatur abhängig, was durch das thermische Anpassnetzwerk berücksichtigt wird. Hierzu kann vorgesehen sein, dass das Anpassnetzwerk dazu ausgebildet ist, die Steuerspannung der Gate-Emitter-Kapazität des Halbleiterschalters in der Amplitude derart anzupassen, dass der Einschaltzeitpunkt des Halbleiterschalters weitgehend unabhängig von der Temperatur ist. Das thermische Anpassnetzwerk ist dabei räumlich nahe am Halbleiterschalter ausgebildet, so dass an ihm die gleichen thermischen Bedingungen vorliegen wie am Halbleiterschalter. Das thermische Anpassnetzwerk kann darüber hinaus weitere Funktionen erfüllen.

Aus dem Energiezwischenspeicher wird über das Anpassnetzwerk die Treiberstufe stufenspezifisch geladen. Neben einer Kompensation von Temperaturunterschieden erfolgt auf diesem Weg die Optimierung des Ein- und Ausschaltverhaltens jeder Leistungsstufe.

Der erwähnte Energietransfer-Schalter kann im Anpassnetzwerk angeordnet sein. Über den Schalter im Anpassnetzwerk wird nach dem Ausschalten des Leistungsschalters die jeweilige Treiberstufe nachgeladen und der Treiber kann für den nächsten Einschaltvorgang getriggert werden. Dabei wird der Energiespeicher der Treiberbaugruppe mit dem Ausgang der Anpassnetzwerk-Baugruppe durch den Energietransfer-Schalter in der Sperrphase des Halbleiterschalters verbunden. So ist die Phase des Energietransfers vom Energiezwischenspeicher über das Anpassnetzwerk auf den Energiespeicher der Treiberbaugruppe in passender Form zum Laststrom während der Ausschaltphase des Halbleiters realisiert.

Bevorzugt ist hierbei vorgesehen, dass das Anpassnetzwerk und der Halbleiterschalter ir räumlicher Nähe und elektrisch isoliert angeordnet sind. Die Art der thermischen Kopplung garantiert eine maximale Temperaturdifferenz von 0,5 K und damit eine vollständige Temperatur-Kompensation jedes Halbleiterschalters. Dabei kann vorgesehen sein, dass die Komponenten der Treiberbaugruppe einschließlich des Anpassnetzwerks sowie der Halbleiterschalter auf einer Dickschichtkeramik realisiert sind. Weiter kann vorgesehen sein, dass Transistoren und Dioden vom Anpassnetzwerk und Halbleiterschalter als Halbleiter-Dies ausgeführt sind und Widerstände durch die Dickschichttechnologie direkt auf einem Schaltungsträger ausgestaltet sind.

Der Hintergrund der Verwendung eines thermischen Anpassnetzwerks besteht darin, dass die - beispielsweise als IGBTs ausgebildeten - Halbleiterschalter durch ihre Positionen auf dem Schaltungsträger im Betriebsfall unterschiedlichen Temperaturen ausgesetzt sind. Der Effekt dieser unterschiedlichen Temperaturen ist beim IGBT beispielsweise, dass die Steuerspannung, ab der der Halbleiterschalter den Wunschstrom leitet, sich nach oben verschiebt. Dieser Effekt wird durch das thermische Anpassnetzwerk ausgeglichen.

Eine weitere Ausgestaltung der Erfindung sieht vor, dass die zwei Schalter der Treiberbaugruppe zur Schaltung des Halbleiterschalters in dem Sinne komplementär arbeiten, dass der eine Schalter geöffnet ist, wenn der andere Schalter geschlossen ist, und umgekehrt, und die beiden Schaltzustände den eingeschalteten Zustand und den ausgeschalteten Zustand des Halbleiterschalters definieren, wobei die beiden Schalter durch die Ausgangsspannung eines Komparators geschaltet werden. Die beiden Schalter sind dabei insbesondere zwei Transistoren, die mit unterschiedlicher Polarität in den Zustand "Ein" und den Zustand "Aus" überführt werden, beispielsweise n- und p-Kanal MOSFETs. Die beiden Schaltzustände (jeweils ein Schalter offen und ein Schalter geschlossen) triggern die Ladephase und die Entladephase der Energiespeicher der Treiberbaugruppe und damit die Einschaltphase und die Ausschaltphase des Halbleiterschalters.

Es wird darauf hingewiesen, dass sich das Hochleistungsschaltmodul mittels der zwei Schalter der Treiberbaugruppe aktiv ein- und ausschalten lässt. Beide Zeitpunkte, das Einschalten und das Ausschalten, erfolgen hochpräzise mit einem Jitter von kleiner 200ps.

Gemäß der Erfindung umfasst das Hochleistungsschaltmodul des Weiteren ein optisches Triggernetzwerk, das mit den Treiberbaugruppen der einzelnen Schaltstufen optisch gekoppelt ist, um die Schaltstufen gleichzeitig zu schalten, wobei das optische Triggernetzwerk eine Mehrzahl von lichtemittierenden Elementen aufweist, die gleichzeitig zwischen einem niedrigen emittierten Lichtstrom und einem hohen emittierten Lichtstrom umschaltbar sind, und jedem lichtemittierenden Element des optischen Triggernetzwerks mindestens ein lichtdetektierendes Element einer Schaltstufe zugeordnet ist, wobei das mindestens eine lichtdetektierende Element abhängig davon, ob es einen niedrigen Lichtstrom oder einen hohen Lichtstrom empfängt, eine Änderung des Schaltzustands der Schaltstufe auslöst.

Die Erfindung beruht auf dem Gedanken, das Trigger-Signal, das die Schaltphase des Halbleiterschalters auslöst, optisch zu übertragen. Alle kapazitiven, induktiven oder galvanischen Koppelwege zwischen dem optischen Triggernetzwerk und den Schaltstufen können so weit minimiert werden, dass sie vernachlässigbar sind. Die optisch getriggerten Treiber der Schaltstufen ermöglichen das Ein- und Ausschalten des Leistungsschalters mit Abweichungen im ps- Bereich.

Das lichtemittierende Element ist beispielsweise eine Leuchtdiode (LED) oder eine Laserdiode, beispielsweise eine VCSEL-Diode. Das lichtdetektierende Element ist beispielsweise eine Fotodiode.

Erfindungsgemäß ist vorgesehen, dass die lichtemittierenden Elemente stufenindividuell auf einen Strom am Arbeitspunkt eingestellt sind, in dem das lichtemittierende Element einen Lichtstrom aussendet, wobei dem Strom am Arbeitspunkt für ein Umschalten auf einen hohen Lichtstrom oder einen niedrigen Lichtstrom ein positiver oder negativer Zusatzstrom aufgeprägt wird (wobei der positive Zusatzstrom den Strom am Arbeitspunkt verstärkt und einen hohen Lichtstrom auslöst und der negative Zusatzstrom den Strom am Arbeitspunkt reduziert und einen niedrigen Lichtstrom auslöst). Der Strom am Arbeitspunkt ist bevorzugt in die Mitte des linearen Bereichs des lichtemittierenden Elements gelegt. Mit dem Triggerstrom dl wird um den Arbeitspunkt gesteuert. Die Arbeitspunkteinstellung erfolgt stufenindividuell, wobei mit der gleichen Stromänderung dl ein Zustandswechsel von "sperrend" nach "leitend" oder umgekehrt stattfinden kann.

Dabei kann vorgesehen sein, dass der Zusatzstrom für sämtliche lichtemittierende Elemente in identischer Weise jeweils kapazitiv durch die Entladung eines Kondensators aufgeprägt wird, wobei die Kondensatoren der jeweiligen Stufen durch eine gesonderte Spannungsquelle mit Spannung beaufschlagt werden, die auch als Primärtrigger oder Impulsspannungsquelle bezeichnet werden kann. Dies erlaubt, sämtliche lichtemittierenden Elemente gleichzeitig in einen jeweils anderen Sendezustand zu überführen.

Weiter kann vorgesehen sein, dass das optische Netzwerk für jede Schaltstufe den Zustand der beiden Schalter steuert. Dies kann beispielsweise in zwei unterschiedlichen Ausführungsvarianten erfolgen. In einer ersten Ausführungsvariante wird für jede Schaltstufe die veränderliche Spannung des zugehörigen lichtdetektierenden Elements dem einen Eingang des Komparators zugeführt, während der andere Eingang des Komparators mit einer Referenzspannung beaufschlagt ist (Schwellentriggerung). In einer zweiten Ausführungsvariante wird für jede Schaltstufe die veränderliche Spannung des zugehörigen lichtdetektierenden Elements dem einen Eingang des Komparators über einen Widerstand und dem anderen Eingang des Komparators über RC-Glied zugeführt, wobei der Spannungsabfall an dem lichtdetektierenden Element mit unterschiedlicher Trägheit den Eingängen des Komparators zugeführt wird. (Flankentriggerung).

Gemäß einem weiteren Erfindungsaspekt ist das Hochleistungsschaltmodul derart ausgebildet, der Halbleiterschalter in Form eines Halbleiter-Dies (d.h. ungehäust) mit einer planen Oberseite und einer planen Unterseite ausgebildet ist, der an seiner planen Oberseite den Emitter-Anschluss und an seiner planen Unterseite den Kollektor-Anschluss ausbildet oder umgekehrt, wobei

- die plane Unterseite des Halbleiter-Dies auf einer planen ersten Leitebene angeordnet ist und über die plane erste Leitebene kontaktiert wird,
- sich unterhalb der planen ersten Leitebene eine plane zweite Leitebene erstreckt,
- sich zwischen der planen ersten Leitebene und der planen zweiten Leitebene eine Isolationsschicht erstreckt, und
- sich von der zweiten planen Leitebene eine Kontaktverbindung zur planen Oberseite des Halbleiter-Dies zur Kontaktierung der planen Oberseite erstreckt.

Gemäß diesem Erfindungsaspekt sind somit die beiden stromführenden Leitebenen, die den Emitteranschluss und den Kollektoranschluss des Halbleiterschalters mit Strom versorgen, in unmittelbarer Nähe in parallelen Ebenen angeordnet und dabei lediglich durch eine dünne Isolierschicht voneinander getrennt. Dies ermöglicht es, dass die Hin- und Rückleiter in der ersten und zweiten Leitebene so angeordnet sind, dass sich ihre Magnetfelder kompensieren.

Dieser Erfindungsaspekt beruht auf dem Gedanken, die Induktivität im hochstromführenden Teil des Schaltsystems weitgehend zu reduzieren, um den Schaltvorgang möglichst wenig zu bremsen und die Schaltsynchronität der Stufen zu erhöhen und präzisen Ein- und Ausschaltvorgang zu ermöglichen. Infolgedessen können eine höhere Stufenzahl des Hochleistungsschaltmoduls für noch höhere Spannungen realisiert werden. Eine Reduktion des Magnetfeldes vom Impulsstrom wird dabei erreicht, indem dieses durch die unmittelbare Nähe des Vorwärtsstromes und des Rückwärtsstromes teilkompensiert wird. Dabei fließt der Vorwärtsstrom in der einen planen Leitebene und der Rückwärtsstrom in der anderen planen Leitebene. Durch die unmittelbare Anordnung der planen Leitebenen parallel zueinander - lediglich getrennt durch die Isolationsschicht - wird die Induktivität reduziert. Die Kompensationen erfolgen dabei längst eines Leiterpfades.

Dabei kann vorgesehen sein, dass die beiden Flächen der einen planen Leitebene und der anderen planen Leitebene mit einem kleinen Versatz übereinander ausgeführt sind. Dieser ist zweckmäßig, um die Verbindungen der Stufen untereinander zu realisieren.

Eine Ausführungsvariante hierzu sieht vor, dass der Abstand zwischen der ersten Leitebene und der zweiten Leitebene weniger als 100 $\mu$m beträgt. Beispielsweise liegt dieser Abstand bei 50 $\mu$m.

Die Isolationsschicht ist beispielsweise als dünne Glasschicht ausgebildet. Die erste Leitebene und die zweite Leitebene bestehen beispielsweise aus Silber.

Gemäß einer weiteren Ausgestaltung der Erfindung ist zumindest der Emitteranschluss des Halbleiterschalters durch mindestens einen flachen (d.h. dünnen und planaren) Kupferbügel kontaktiert, dessen Breite seine Dicke beispielsweise um mindestens den Faktor 1,5 und dessen Länge seine Dicke um mindestens den Faktor 2,5 übersteigen (was die Eigenschaft als "Bügel" definiert) Beispielsweise beträgt die Länge des Kupferbügels 8mm, die Breite 5mm und die Dicke 3mm. In anderen Ausgestaltungen kann der genannte Faktor bei dem Verhältnis Breite zu Dicke bei mindestens 2 oder mindestens 5 und bei dem Verhältnis Länge zu Dicke bei mindestens 3 oder mindestens 10 liegen. Auch der Steueranschluss des Halbleiterschalters kann über flache Kupferbügel kontaktiert sein.

Diese Ausgestaltung der Erfindung beruht auf dem Gedanken, typischerweise eingesetzte Bonddrähte durch flache Kupferbügel zu ersetzen. Ein Vorteil von flachen Kupferbügeln besteht darin, dass sie robuster als Bonddrähte sind und Wärme gut ableiten, was für hohe Schaltfrequenzen vorteilhaft ist. Des Weiteren kann in Ausführungsvarianten verglichen mit einer durch Bonddrähte erfolgenden Stromübertragung eine reduzierte Anzahl von Kupferbügel eingesetzt werden, da diese eine größere Oberfläche zur Stromübertragung aufweisen. Damit verbunden ist eine Reduktion der Induktivität, was wiederum eine erhöhte Schaltgeschwindigkeit ermöglicht.

Eine Ausgestaltung hierzu sieht vor, dass bei Ausbildung des Halbleiterschalters als ungehäustes Halbleiter-Die die Kontaktverbindung zumindest des Emitteranschlusses des Halbleiterschalters durch mindestens einen Kupferbügel bereitgestellt wird, der sich von der zweiten planen Leitebene zur planen Oberseite des Halbleiter-Dies für eine Emitter-Kontaktierung erstreckt.

Eine weitere Ausgestaltung sieht dabei vor, dass zwei Kupferbügel zur Kontaktierung der planen Oberseite des Halbleiter-Dies vorgesehen sind.

Es wird allgemein darauf hingewiesen, dass der Halbleiterschalter auf vielfältige Weise ausgeführt sein kann. Ausführungsvarianten sehen vor, dass der Halbleiterschalter ein Feldeffekttransistor (FET), beispielsweise ein Metall-Oxid-Halbleiter-Feldeffekttransistor (MOSFET), ein Bipolartransistor mit isolierter Gate-Elektrode ("Insulated-Gate Bipolar Transistor" - IGBT) oder ein mos-controlled-Thyristor ist.

Die vorliegende Erfindung betrifft also ein Hochleistungsschaltmodul zur direkten hochpräzisen Pulsenergiespeisung eines Verbrauchers mit einer Mehrzahl in Reihe geschalteter Schaltstufen, wobei jede Schaltstufe aufweist:

- einen Halbleiterschalter mit Kollektoranschluss, Emitteranschluss und Steueranschluss, der abhängig von der am Steueranschluss anliegenden Spannung einen eingeschalteten Zustand, in dem zwischen dem Kollektoranschluss und dem Emitteranschluss ein Strom fließt, und einen ausgeschalteten Zustand, in dem zwischen dem Kollektoranschluss und dem Emitteranschluss kein Strom fließt, aufweist, und
- eine auf den Halbleiterschalter einwirkende Treiberbaugruppe, wobei die Treiberbaugruppe zwei Schalter zur Steuerung des Steueranschlusses des Halbleiterschalters sowie einen Energiespeicher aufweist, der Energie für das Einschalten des Halbleiterschalters bereitstellt.

Dabei ist ein optisches Triggernetzwerk in jeder Stufe vorgesehen, das mit den Treibernetzwerken der einzelnen Schaltstufen optisch gekoppelt ist, um die Schaltstufen gleichzeitig zu schalten, wobei das optische Triggernetzwerk eine Mehrzahl von lichtemittierenden Elementen aufweist, die gleichzeitig zwischen einem niedrigen emittierten Lichtstrom und einem hohen emittierten Lichtstrom umschaltbar sind, und jedem lichtemittierenden Element des optischen Triggernetzwerks mindestens ein lichtdetektierendes Element einer Schaltstufe zugeordnet ist, wobei das mindestens eine lichtdetektierende Element abhängig davon, ob es einen niedrigen Lichtstrom oder einen hohen Lichtstrom empfängt, eine Änderung des Schaltzustands der Schaltstufe auslöst.

Die Erfindung beruht auf dem Gedanken, das Trigger-Signal, das ein Schalten des Halbleiterschalters auslöst, optisch bereitzustellen. Hierdurch ist das triggereinleitende System von Störungen ausgeschlossen, da es galvanisch, kapazitiv und induktiv von hohen Impulsströmen aus dem Lastkreis entkoppelt ist.

Gemäß der Erfindung ist vorgesehen, dass die lichtemittierenden Elemente und/oder die lichtdetektierenden Elemente mittels zugeordneter Einstellmittel derart stufenindividuell eingestellt sind, dass in dem Zustand, in dem das lichtemittierende Element einen niedrigen Lichtstrom emittiert, das zugeordnete lichtdetektierende Element an der Schwelle zur Detektion eines hohen Lichtstroms liegt.

Eine Ausgestaltung sieht vor, dass das optische Netzwerk für jede Schaltstufe den Zustand der zwei Schalter steuert, die in dem Sinne komplementär arbeiten, dass der eine Schalter geöffnet ist, wenn der andere Schalter geschlossen ist, und umgekehrt, und die beiden Schaltzustände den eingeschalteten Zustand und den ausgeschalteten Zustand des Halbleiterschalters definieren, wobei die beiden Schalter durch die Ausgangsspannung eines Komparators geschaltet werden und das optische Netzwerk für jede Schaltstufe über den vom lichtdetektierenden Element detektierten Lichtstrom den Komparator steuert.

In einem weiteren Erfindungsaspekt betrifft die vorliegende Erfindung ein Hochleistungsschaltmodul zur direkten Pulsenergiespeisung eines Verbrauchers mit einer Mehrzahl in Reihe geschalteter Schaltstufen, wobei jede Schaltstufe aufweist:

- einen Halbleiterschalter mit Kollektoranschluss, Emitteranschluss und Steueranschluss, der abhängig von der am Steueranschluss anliegenden Spannung einen eingeschalteten Zustand, in dem zwischen dem Kollektoranschluss und dem Emitteranschluss ein Strom fließt, und einen ausgeschalteten Zustand, in dem zwischen dem Kollektoranschluss und dem Emitteranschluss kein Strom fließt, aufweist, und

- eine auf den Halbleiterschalter einwirkende Treiberbaugruppe, wobei die Treiberbaugruppe zwei Schalter zur Steuerung des Steueranschlusses des Halbleiterschalters sowie einen Energiespeicher aufweist, der Energie für das Einschalten des Halbleiterschalters bereitstellt.

Dabei ist gemäß diesem Erfindungsaspekt der Halbleiterschalter neben den Merkmalen des Anspruchs 1 in Form eines Halbleiter-

Dies mit einer planen Oberseite und einer planen Unterseite ausgebildet. Das Halbleiter-Die bildet an seiner planen Oberseite den Emitter-Anschluss und an seiner planen Unterseite den Kollektor-Anschluss aus oder umgekehrt. Es ist vorgesehen, dass die plane Unterseite des Halbleiter-Dies auf einer planen ersten Leitebene angeordnet ist und über die plane erste Leitebene kontaktiert wird. Unterhalb der planen ersten Leitebene erstreckt sich eine plane zweite Leitebene. Beide planen Leitebenen sind als flächige Schicht ausgebildet. Weiter erstreckt sich zwischen der planen ersten Leitebene und der planen zweiten Leitebene eine Isolationsschicht. Von der zweiten planen Leitebene erstreckt sich eine Kontaktverbindung zur planen Oberseite des Halbleiter-Dies zur Kontaktierung der planen Oberseite.

Dieser Erfindungsaspekt beruht auf dem Gedanken, das Magnetfeld vom Impulsstrom im Bereich des Halbleiterschalters zu reduzieren, indem dieses durch die unmittelbare Nähe des Vorwärtsstromes und des Rückwärtsstromes teilkompensiert wird. Dabei fließt der Vorwärtsstrom in der einen planen Leitebene und der Rückwärtsstrom in der anderen planen Leitebene. Durch die unmittelbare Anordnung der planen Leitebenen parallel zueinander - lediglich getrennt durch die Isolationsschicht - kann die Induktivität reduziert werden. Insbesondere werden die Magnetfelder um den Hauptstromfluss bzw. Bus kompensiert.

Eine Ausführungsvariante hierzu sieht vor, dass zumindest der Emitteranschluss des Halbleiterschalters durch mindestens einen flachen Kupferbügel kontaktiert ist.

Die Erfindung wird nachfolgend unter Bezugnahme auf die Figuren der Zeichnung anhand mehrerer Ausführungsbeispiele näher erläutert. Es zeigen:

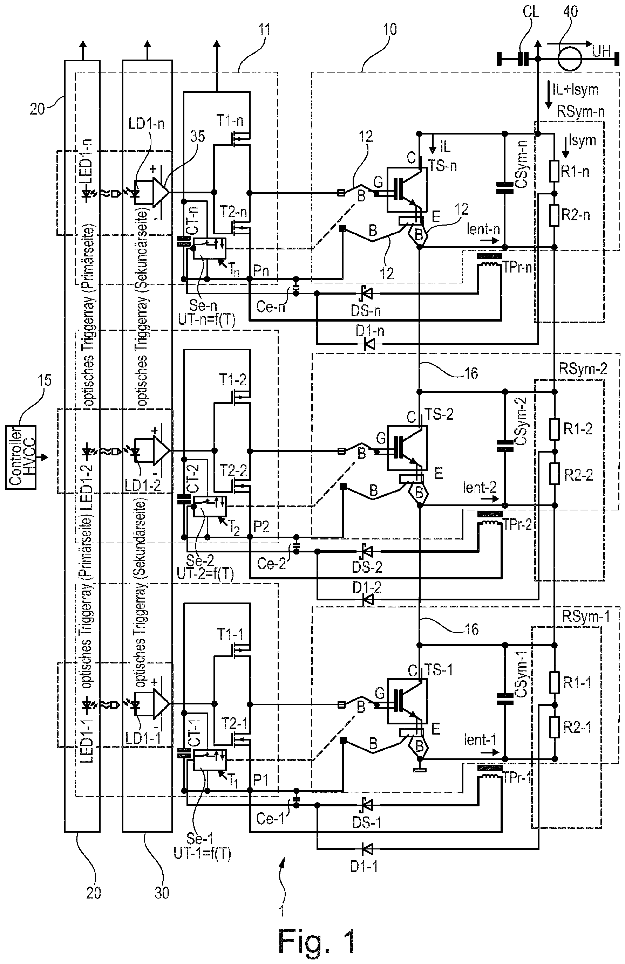

Figur 1    ein Beispiel eines kaskadierbaren Hochleistungsschaltmoduls zur direkten Pulsenergiespeisung eines Verbrauchers, welches eine Mehrzahl in Reihe geschalteter Schaltstufen aufweist, die jeweils einen Halbleiterschalter und einen Energiespeicher umfassen, wobei in jeder Schaltstufe ein Primärkreis den Halbleiterschalter und eine parallel zum Halbleiterschalter geschaltete Symmetrisierkapazität umfasst und ein Sekundärkreis einen Energiezwischenspeicher umfasst, wobei die Energie der Symmetrisierkapazität über ein Koppelglied auf den Energiezwischenspeicher des Sekundärkreises und von diesem auf den Energiespeicher übertragen wird;

Figur 2    eine der Schaltstufen des Hochleistungsmoduls der Figur 1, wobei das Koppelglied ein Transformator ist, der Energie aus dem Primärkreis auf den Energiezwischenspeicher transferiert;

Figur 3    ein Ausführungsbeispiel des Transformators gemäß der Figur 2, wobei der Transformator als Printtransformator mit einer breiten Leitung auf der Primärseite, die eine Schlaufe bildet, und einem in die Schlaufe eingeführten, mit einer Sekundärwicklung versehenen Wickelkörper gebildet ist;

Figur 4    eine der Schaltstufen eines Hochleistungsmoduls entsprechend der Figur 1 in einer Abwandlung dahingehend, dass das Koppelglied ein Kondensator ist, der Energie aus dem Primärkreis auf den Energiezwischenspeicher der Treiberbaugruppe transferiert und diesen positiv auflädt;

Figur 5    eine weitere Abwandlung einer Schaltstufe eines Hochleistungsmoduls entsprechend der Figur 1, wobei das Koppelglied ein Kondensator ist, der Energie aus dem Primärkreis auf den Energiezwischenspeicher der Treiberbaugruppe transferiert und diesen negativ auflädt;

Figur 6    schematisch ein optisches Trigger-Netzwerk eines Hochleistungsschaltmoduls zur direkten Pulsenergiespeisung eines Verbrauchers, wobei das optische Trigger-Netzwerk ein synchrones Schalten sämtlicher Schaltstufen des Hochleistungsschaltmoduls über eine Flankentriggerung optisch triggert, sowie zwei zugeordnete Diagramme, die die Strom-Spannung-Kennlinie zeigen;

Figur 6a    ein optisches Trigger-Netzwerk gemäß der Figur 6, wobei die Schaltstufen des Hochleistungsmoduls über eine Schwellentriggerung optisch getriggert werden;

Figur 7    ein Ausführungsbeispiel der Leitebenen in einer Schaltstufe in zwei perspektivischen Darstellungen, wobei der Halbleiterschalter als Nacktchip ausgebildet ist, der durch zwei plane und parallel zueinander angeordnete Leitebenen, die durch eine Isolationsschicht voneinander getrennt sind, bestromt wird, wobei eine Kontaktierung des Emitteranschlusses des Halbleiterschalters über flache Kupferbügel erfolgt;

Figur 8    einen Stackaufbau mit einer Mehrzahl von entsprechend der Figur 7 ausgebildeten Schaltstufen;

Figur 9    die Übertragungscharakteristik eines als IGBT ausgebildeten Halbleiterschalters in Abhängigkeit von der Temperatur auf dem Halbleiter;

Figur 10    schematisch die thermische Anpassung der Spannung am Steueranschluss des Halbleiterschalters durch ein Anpassungsnetzwerk, welches thermisch an die Schaltelemente der zugehörigen Stufen gekoppelt ist; und

Figur 11    ein Ausführungsbeispiel für ein Anpassungsnetzwerk, wie es in dem Hochleistungsmodul gemäß Figur 1 in den einzelnen Schaltstufen einsetzbar ist, wobei das Anpassungsnetzwerk die Steuerspannung des Halbleiterschalters der jeweiligen Schaltstufe temperaturabhängig beeinflusst.

Die Figur 1 zeigt ein Hochleistungsschaltmodul 1, das eine Mehrzahl von identisch ausgebildeten Schaltstufen 10 umfasst, wobei in der Figur 1 drei solcher Schaltstufen 10 dargestellt sind.

Jede Schaltstufe 10 weist einen Halbleiterschalter TS-n auf. Dem Halbleiterschalter TS-n ist eine auf den Halbleiterschalter TS-n einwirkende Treiberbaugruppe 11 zugeordnet. Die Treiberbaugruppe 11 umfasst zwei Schalter T1-n, T2-n, die den Steueranschlusses G des Halbleiterschalters TS-n schalten, sowie einen Energiespeicher CT-n in Form eines Kondensators, der Energie für das Einschalten des Halbleiterschalters TS-n bereitstellt. Dabei wird mit dem Schalter T1-n der Halbleiterschalter TS-n eingeschaltet und mit T2-n ausgeschaltet. Der Energiespeicher CT-n stellt dabei Energie für den Halbleiterschalter TS-n bereit, wenn der Schalter T1-n eingeschaltet ist. Wenn der Schalter T2-n eingeschaltet ist, so wird der Halbleiterschalter TS-n schnell ausgeschaltet, da der Steueranschluss G mit dem Emitteranschluss E verbunden wird und die Steuerspannung sich schnell auf 0V abbaut.

Die Treiberbaugruppe 11 umfasst des Weiteren ein Anpassnetzwerk T, das die Steuerspannung des Halbleiterschalters TS-n temperaturabhängig beeinflusst, wie noch im Einzelnen erläutert wird. Die Treiberbaugruppe 11 kann weitere Komponenten wie Dioden und Widerstände enthalten, wie dem Fachmann an sich bekannt ist.

Weiter umfasst die Schaltstufe 10 eine Symmetrisierkapazität CSym-n, die parallel zum Halbleiterschalter TS-n zwischen Kollektoranschluss C und Emitteranschluss E geschaltet ist. Die Symmetrisierkapazität CSym-n und der Halbleiterschalter TS-n sind dabei in einem Primärkreis (auch als Symmetrisierkreis bezeichnet) angeordnet. Der Primärkreis umfasst des Weiteren die Primärwicklung eines Transformators TPr-n, der ein induktives Koppelglied bildet. Die Sekundärwicklung des Transformators TPr-n ist in einem Sekundärkreis ausgebildet, wobei der Sekundärkreis neben der Sekundärwicklung des Transformators eine Diode DS-n und einen Energiezwischenspeicher Ce-n aufweist. Der Energiezwischenspeicher und der Transformator TPr-n dienen dazu, von der Symmetrisierkapazität CSym-n erhaltene Energie im Sekundärkreis an den Energiespeicher CT-n abzugeben, während der Sperrphase des Halbleiterschalters.

Die Spannungsversorgung des Hochspannungsmoduls erfolgt über mindestens eine Hochspannungsquelle 40, die eine Gleichspannung UH bereitstellt, wobei an jeder von n Schaltstufen 10 eine Teilspannung $Un = UH/n$ anliegt, die einen Bruchteil der Spannung der Hochspannungsquelle 40 darstellt. Die über jeder Schaltstufe 10 anliegende Spannung liegt beispielsweise im Kilovolt-Bereich. Das Hochschaltungsmodul ist dazu vorgesehen und ausgebildet, aus der Hochspannungsquelle 40 eine ohmsche, induktive oder kapazitive Last zu laden oder eine kapazitive oder induktive Quelle zu entladen oder umzuladen.

So umfasst das Hochleistungsschaltmodul 1 des Weiteren eine Lastkapazität CL. Ein Laststrom IL des Hochleistungsschaltmoduls 1 fließt aus der Lastkapazität CL, wenn das Hochleistungsschaltmodul 1 einschaltet. Der Laststrom IL fließt dabei durch das komplette Hochleistungsschaltmodul 1. Er ist dabei in allen Stufen gleich. Um eine Hochstromentladung mit extrem kurzer Pulsdauer zu erreichen, ist es dabei erforderlich, dass die Halbleiterschalter TS-n jeder Stufe 10 exakt synchron geschaltet werden.

Es wird darauf hingewiesen, dass in der Darstellung der Figur 1 den einzelnen Bauelementen wie zum Beispiel dem Halbleiterschalter TS-n eine Zahl 1, 2, ...n zugefügt ist, die die jeweilige Schaltstufe indiziert.

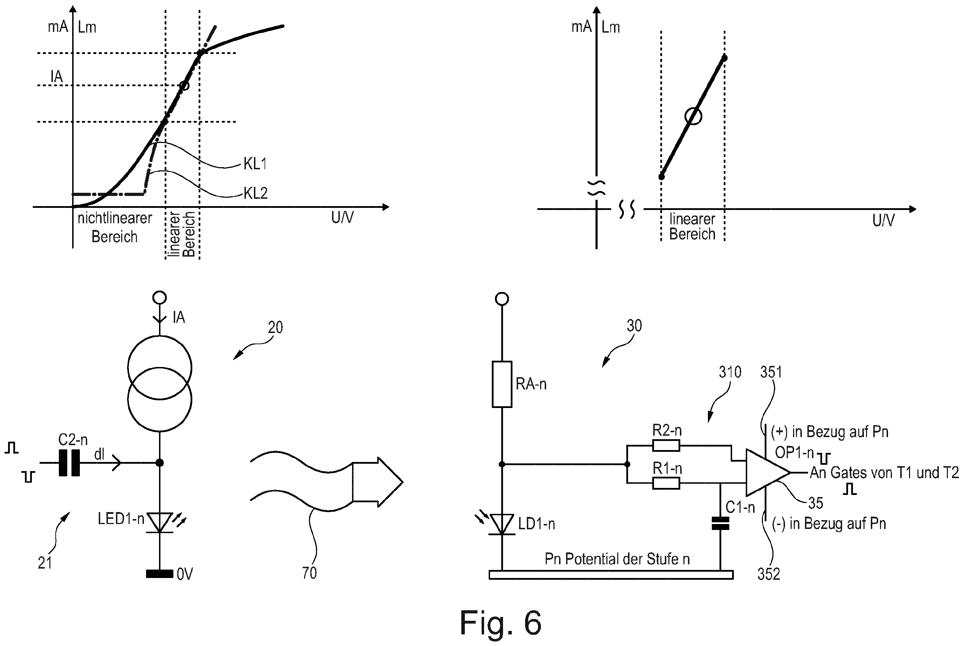

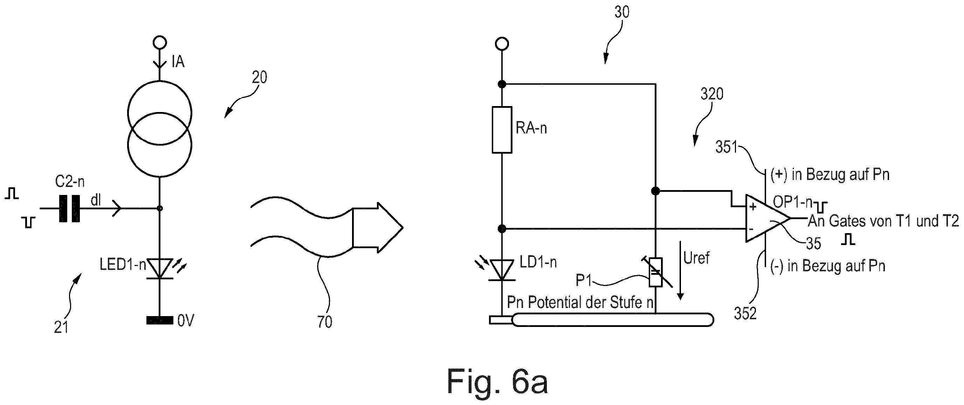

Das synchrone Schalten der Halbleiterschalter TS-n sämtlicher Schaltstufen 10 wird durch ein schematisch dargestelltes optisches Netzwerk 20 getriggert, das ein sendeseitiges optisches Triggerarray aufweist, wobei ein empfangsseitiges optisches Triggerarray 30 den Schaltzustand der Schalter T1-n, T2-n jeder Schaltstufe 10 definiert. Das optische Netzwerk 20 wird anhand der Figuren 6, 6a erläutert.

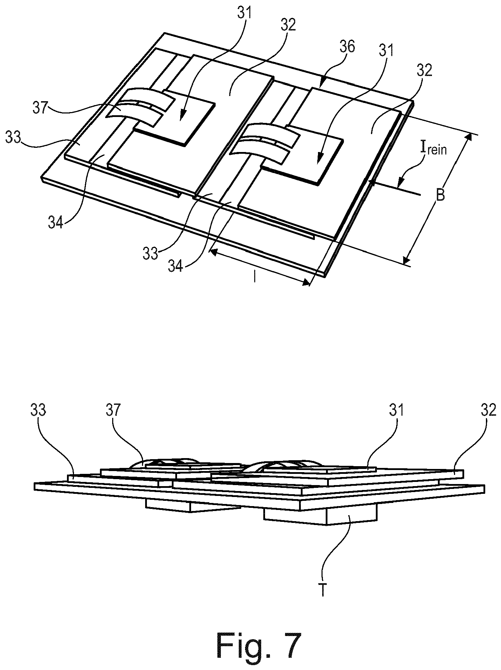

Bei synchronem Schalten der Halbleiterschalter TS-n fließt der Laststrom IL über Leitungen 16, die jeweils Kollektoranschluss C und Emitteranschluss E der Halbleiterschalter TS-n zweier benachbarter Schaltstufen 10 direkt verbinden, durch das komplette Hochleistungsschaltmodul 1. Ein Ausführungsbeispiel solcher Leitungen 16 ist in der Figur 7 dargestellt und dort erläutert. Dabei ist die Leitung 16 zum Halbleiterschalter TS-n gestrichelt dargestellt, um zu verdeutlichen, dass zwischen TS-2 und TS-n weitere Halbleiterschalter bzw. Schaltstufen 10 realisiert sein können.

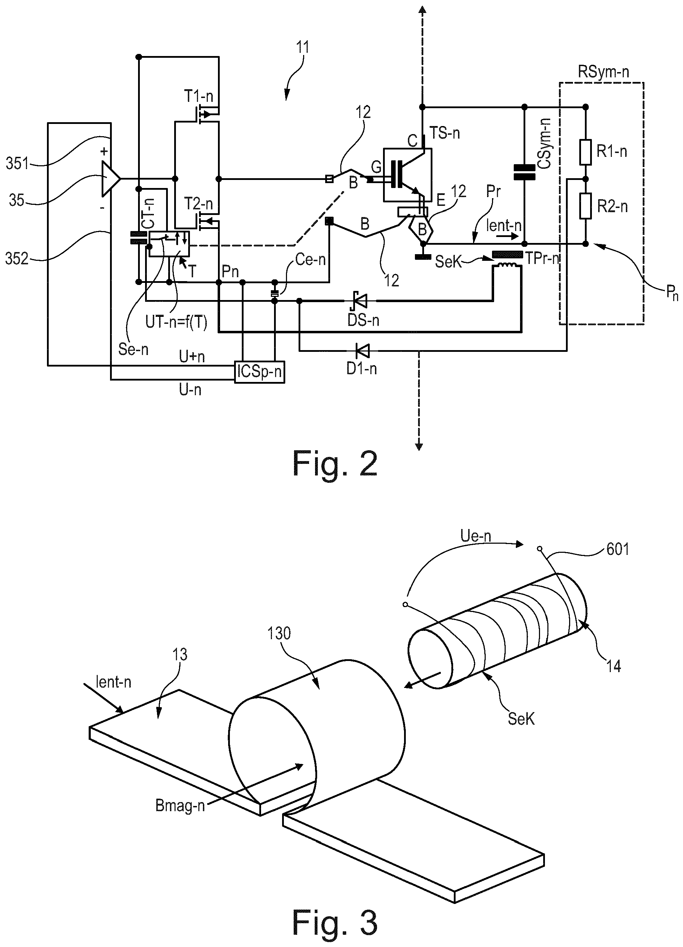

Jeder Schaltstufe 10 umfasst des Weiteren einen Symmetriewiderstand Rsym-n, der in Bezug auf die Figur 2 erläutert wird.

Die Figur 2 zeigt den Aufbau einer Schaltstufe 10 des Hochleistungsmoduls 1 in vergrößerter Darstellung. Dabei gilt, dass sämtliche Schaltstufen identisch aufgebaut sind.

Der Halbleiterschalter TS-n weist einen Kollektoranschluss C, einen Emitteranschluss E und einen Steueranschluss G auf, wobei der Steueranschluss G abhängig von der am Steueranschluss G anliegenden Spannung einen eingeschalteten Zustand, in dem zwischen dem Kollektoranschluss C und dem Emitteranschluss E ein Strom fließt, und einen ausgeschalteten Zustand, in dem zwischen dem Kollektoranschluss C und dem Emitteranschluss E kein Strom fließt, aufweist. Parallel zum Halbleiterschalter TS-n zwischen dem Kollektoranschluss C und dem Emitteranschluss E ist die Symmetrisierkapazität CSym-n geschaltet.

Es wird darauf hingewiesen, dass die Kontaktierung des Steueranschlusses G und des Emitteranschlusses E des Transistors TS-n über schematisch dargestellte Bonddrähte oder alternativ über Kupferbügel 12 erfolgt, wie anhand der Figur 7 beispielhaft erläutert wird.

Der Transformator TPr-n weist eine Primärwicklung pr im Primärkreis und eine Sekundärwicklung sek im Sekundärkreis auf. Die in der Symmetrisierkapazität CSym-n gespeicherte Energie wird über den Transformator TPr-n in den Energiezwischenspeicher Ce-n übertragen. Von diesem wird in der Sperrphase des Halbleiterschalters über einen Energietransfer-Schalter Se-n die Energie in den Energiespeicher CT-n der Treiberbaugruppe 11 übertragen. Der Transformator TPr-n wird primärseitig vom stufeninternen Entladestrom Ient-n der Symmetrisierkapazität Csym-n in jeder Stufe 10 durchflossen. Die vom Sekundärkreis ausgekoppelte Energie wird dem Energiezwischenspeicher Ce-n der Treiberbaugruppe 11 zugeführt und dort zwischengespeichert. Dabei wird die durch die Sekundärwicklung des Printtransformators TPr-n bereitgestellte Spannung Ue-n als Energie dem Energiezwischenspeicher Ce-n bereitgestellt.

Abhängig vom gewählten Wickelsinn der Sekundärwicklung können positive oder negative Stromversorgungen nachgeladen werden. Dabei ist allgemein vorgesehen, dass die Energie bereits in der Einschaltphase des Halbleiterschalters TS-n an den Energiezwischenspeicher Ce-n weitergegeben wird (wenn im Primärkreis Strom fließt). Wenn der Halbleiterschalter TS-n sperrt, so verbindet der Energietransfer-Schalter Se-n in der gleichen Phase den Energiezwischenspeicher Ce-n mit dem Energiespeicher CT-n der Treiberbaugruppe.

Die beiden als Transistoren ausgebildeten Schalter T1-n, T2-n, die mit unterschiedlicher Polarität ein- bzw. ausgeschaltet werden, werden durch das optische Netzwerk 20 komplementär getriggert. Das empfangsseitige optische Triggerarray 30 umfasst dabei den Komparator 35, dessen Ausgangsspannung die beiden Schalter T1-n, T2-n schaltet.

Bei dem Halbleiterschalter TS-n handelt es sich beispielsweise um einen FET, einen MOSFET oder ein IGBT.

Die Schaltstufe umfasst des Weiteren einen sogenannten Symmetrie-Strompfad. Der Symmetrie-Strom lädt die Energiezwischenspeicher Ce-n auf. Dabei werden, da der Energietransfer-Schalter Se-n in der Sperrphase des Halbleiterschalters TS-n immer geschlossen ist, gleichzeitig die Energiespeicher CT-n der einzelnen Treiberbaugruppen 11 aufgeladen. Der Symmetrie-Strom ist für eine statische Spannungsaufteilung an den Schaltstufen 10 verantwortlich. Der durch den Energiezwischenspeicher bzw. Transformator TPr-n bereitgestellte Strom wird zusätzlich zu diesem Symmetrie-Strom am Energiespeicher CT-n bereitgestellt.

Der Symmetrie-Strompfad wird durch einen Symmetriewiderstand Rsym-n bereitgestellt, der aus zwei in Reihe geschalteten Widerständen R1-n und R2-n gebildet ist, wobei Rsym-n parallel zum Lastpfad durch den Halbleiterschalter TS-n angeordnet ist. Ein kleiner Symmetrie-Strom fließt dabei auch im Sperrzustand der Halbleiterschalter TS-n. Dabei ist vorgesehen, dass der Widerstand R1-n hochohmiger ausgebildet ist als der Widerstand R2-n, so dass der Großteil der Stufenspannung Un (zum Beispiel 90 %) an R1-n abfällt. An R2-n fällt ein positiver Kleinbetrag ab.

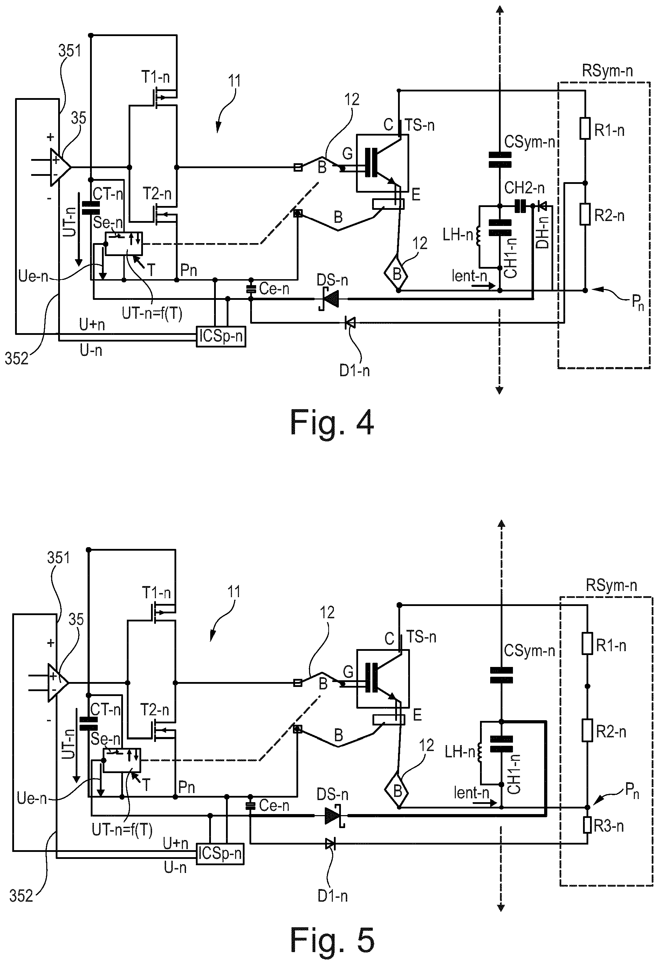

Wenn ein negativer Spannungsbeitrag durch Initialladung erzeugt werden muss, so ist ein weiterer Widerstand R3-n vorgesehen, an dem ein negativer Kleinbetrag abfällt. Dieser Sonderfall ist in Figur 5 dargestellt.

Die Verhältnisse der Widerstände R1-n und R2-n und ggf. R3-n zueinander bestimmen die Spannungen. Hinter dem Widerstand R2-n - bzw. bei der Ausgestaltung der Figur 5 zwischen den beiden Widerständen R2-n und R3-n - liegt dabei das Bezugspotenzial Pn an. Über die Primärwicklung pr des Transformators TPr-n und die Bonddrähte bzw. Kupferbügel 12 liegt dieses Bezugspotenzial Pn und auch am Energiespeicher CT-n und sorgt für dessen Energieversorgung über den Symmetrie-Strompfad, indem während der Sperrphase des Halbleiterschalters bzw. über einen geschlossenen Energietransfer-Schalter Se-n und die Diode D1-n ein Stromkreis für die Initialladung geschlossen ist.

Der Bezugspunkt für jede Spannung einer Stufe ist dabei immer das Bezugspotenzial Pn. Wenn eine Spannung höher als Pn ist, so wird diese als positive Spannung betrachtet. Wenn eine Spannung niedriger als Pn ist, so wird sie als negative Spannung betrachtet.

Die Figur 2 zeigt des Weiteren einen Komparator 35, an dem an Versorgungsleitungen 351, 352 eine positive Spannung + und eine negative Spannung - anliegt. Die Ausgangsspannung des Komparators 35 steuert die Gate-Anschlüsse der komplementär aufgebauten Transistoren bzw. Schalter T1-n, T2-n. Die Versorgungsleitungen 351, 352 erzeugt ein Dualsperrwandler ICSp-n, dessen Eingang von einem Teil des Symmetriestroms, der über den Symmetriewiderstand Rsym-n bereitgestellt wird, versorgt wird. Der Dualsperrwandler ICSP-n ist ein Schaltkreis, der aus einer Eingangsspannung (hier: einer positiven Spannung) zwei polarisierte Spannungen an seinem Ausgang erzeugt, die die Spannungen an den Versorgungsleitungen 351, 352 darstellen.

Zum besseren Verständnis der Bedeutung des Transformators TPr-n wird zunächst der Zustand gedanklich betrachtet, in dem der Transformator TPr-n nicht vorhanden bzw. durch einen Kurzschluss ersetzt ist. Einem solchen Fall wird der Energiespeicher CT-n der Treiberbaugruppe 11 nur durch den erwähnten Symmetrie-Strom nachgeladen. Eine Schaltfrequenzerhöhung der Schaltstufe kann bei einer solchen Schaltung nur durch das Erhöhen des Symmetrie-Stroms erreicht werden, was jedoch eine Widerstandsverringerung im Treibernachladestrom verlangt und mit der Entstehung von zusätzlicher Wärme verbunden ist. Ein Erhöhen des Symmetrie-Stroms führt mit zunehmender Schaltfrequenz zu einem Zustand, in dem der Treiber genau so viel Energie benötigt wie beispielsweise die kapazitive Nutzlast CL, die parallel zum Hochspannungsschaltmodul 1 angeschlossen ist. Alternativ kann eine induktive Nutzlast in Reihe zum Hochspannungsschaltmodul 1 geschaltet sein. Durch die Energierückgewinnung über den Transformator TPr-n lassen sich in effektiver Weise die Schaltfrequenzen der Schaltstufen erhöhen, ohne den Symmetrie-Strom durch eine Widerstandsverringerung im Treibernachladestrom erhöhen zu müssen.

Somit wird die Energie aus der Symmetrisierkapazität CSym-n nicht komplett in Wärme während des Einschaltvorganges umgewandelt, sondern ein Teil der Energie wird in Nutzenergie für den Energiespeicher CT-n der Treiberbaugruppen 11 umgewandelt. Da die von der Symmetrisierkapazität CSym-n ohne eine Energienachnutzung abgegebene Wärme typischerweise vom Halbleiterschalter TS-n aufgenommen würde, werden dadurch auch die durch Wärme verursachten Verluste am Halbleiterschalter TS-n verringert.

Beide Effekte steigern die Effizienz jeder Schaltstufe 10 und damit des Hochleistungsschaltmoduls 1 insgesamt und ermöglichen eine höhere Schaltfrequenz. Natürlich kann das Hochleistungsschaltmodul 1 auch bei tieferen Schaltfrequenzen betrieben werden. Ein Hauptvorteil liegt dann in einer Reduzierung der Wärme, wobei die Regel gilt, dass eine Verringerung der Temperatur um 10K die Lebensdauer der Elektronik verdoppelt.

Es wird nochmals darauf hingewiesen, dass die nachgenutzte Energie aus der Symmetrisierkapazität Csym-n stammt. Diese Kapazität verursacht in jeder Stufe den Strom Ient-n. Dieser Strom addiert sich zusätzlich zum Laststrom IL pro Stufe. Die Symmetrisierkapazität Csym-n ist dabei für die dynamische Spannungsaufteilung notwendig.

Der Symmetriewiderstand Rsym-n stellt für den Energiespeicher CT-n eine Stromquelle dar, die u.a. in jeder Stufe die Initialladung auf den Energiespeicher CT-n bringt. Vor dem ersten Schaltvorgang muss der Energiespeicher CT-n auf die notwendige Initialspannung geladen werden, bevor die Energienachnutzung stattfindet. Der Widerstand Rsym-n sorgt in jeder Stufe dafür, dass die Teilspannung Un pro Stufe sich auf einen n-ten Anteil Wert der Hochspannung UH einstellt. Es gilt: Un= UH/n. Beim ersten Schaltvorgang gibt CT-n die Initialladung an das Gate des Halbleiterschalters TS-n ab, die über den Symmetriewiderstand Rsym-n aufgebaut wurde. Der Halbleiterschalter TS-n führt dann den Strom Ient-n, der die Primärseite pr des Transformators TPr-n durchfließt. Ein auf der Sekundärseite sek dadurch erzeugter Sekundärstrom lädt den Energiezwischenspeicher Ce-n der Treiberbaugruppe zusätzlich auf. Für alle nachfolgenden Schaltvorgänge spielt dann der Strom über den Symmetriewiderstand Rsym-n eine untergeordnete Rolle, da der Energiezwischenspeicher Ce-n über die nachgenutzte Energie aus der Symmetrisierkapazität Csym-n aufgeladen wird. Und diese zwischengespeicherte Energie in der Sperrphase des Halbleiterschalters TS-n über den geschlossenen Energietransfer-Schalter Se-n an den Energiespeicher der Treiberbaugruppe CT-n weitergegeben wird.

Die Figur 3 zeigt beispielhaft ein Ausführungsbeispiel eines Transformators TPr-n gemäß der Figur 2, der als Printtransformator ausgebildet ist. Der Strom Ient-n durchfließt, wenn im Primärkreis Strom fließt, eine breite und flache Leitung 13, beispielsweise eine Emitterfläche, die eine Modifikation in Form einer Schlaufe 130 aufweist. Die Leitung 13 mit der Schlaufe 130 bildet dabei die Primärwicklung des Printtransformators TPr-n. Infolge des Stromes Ient-n bildet sich ein Magnetfeld Bmag-n aus.

Die Sekundärwicklung des Printtransformators TPr-n wird im betrachteten Ausführungsbeispiel durch eine Sekundärwicklung sek gebildet, die auf einen Wickelkörper 14 aufgebracht ist, der zylindrisch ausgebildet und dazu vorgesehen ist, in die Schlaufe 130 eingesteckt zu werden. So sind beide Stromkreise (primärer und sekundärer Stromkreis) magnetisch miteinander gekoppelt. Da das Magnetfeld Bmag-n die Sekundärwindung sek durchsetzt, wenn der Wickelkörper 14 in die Schlaufe 130 eingeführt ist, wird in dessen Windungen abhängig vom Wicklungssinn eine positive Spannung oder eine negative Spannung Ue-n induziert, wie schematisch in der Figur 3 dargestellt. Ausführungsvarianten können dabei vorsehen, dass ein Hochleistungsschaltmodul 1 mit Halbleiterschaltern TS-n realisiert wird, die mit einer negativen Spannung an der Steuerelektrode G eingeschaltet werden oder mit einer negativen Spannung im Sperrzustand gehalten werden und mit Spannung über 0V leitend sind. Der Pfeil ist von Plus nach Minus (=Pfeilspitze) gezeichnet.

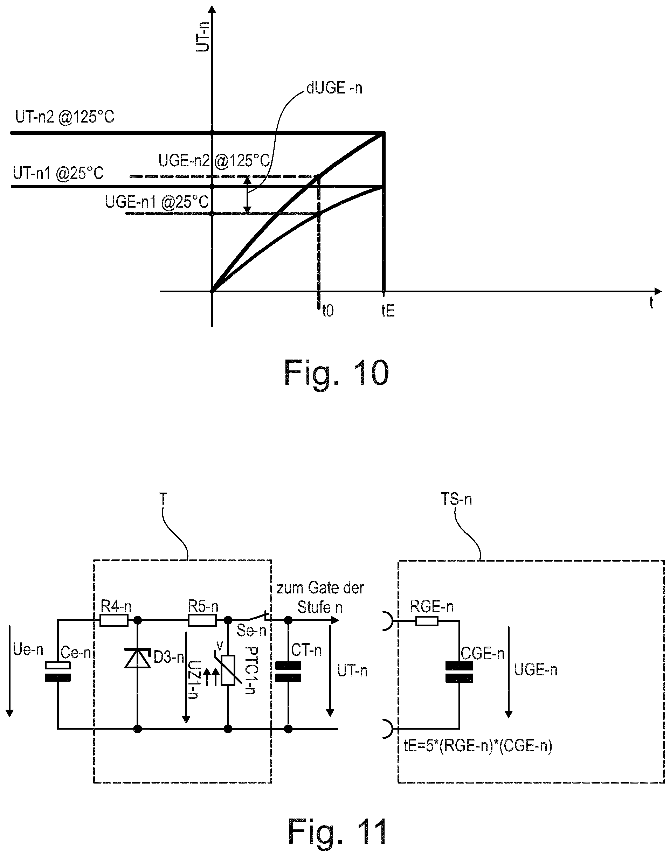

Dabei wird die Spannung Ue-n dem Energiezwischenspeicher Ce-n der Treiberbaugruppe bereitgestellt, und zwar über das Anpassungsnetzwerk T und im Sperrzustand des Halbleiterschalters TS-n über den Energietransfer-Schalter Se-n dem Energiespeicher der Treiberbaugruppe CT-n, wie anhand der Figur 11 noch erläutert wird. Dabei verhält es sich so, dass der Strom Ient-n im Primärkreis gemäß Figur 2 einen Impulsstrom im Sekundärkreis verursacht, der zu der Spannung Ue-n führt.

Erneut Bezug nehmend auf die Figuren 1 und 2 wird die Spannung Ue-n an den Energiezwischenspeicher in Form der Kapazität Ce-n angelegt. Die über die Kapazität Cen anliegende Spannung wird dann wie erwähnt noch durch das thermisch gekoppelte Anpassnetzwerk T in der Amplitude angepasst und dem Energiespeicher CT-n der betrachteten Treiberbaugruppe über den geschlossenen Energietransfer-Schalter Se-n in der Sperrphase des Halbleiterschalters TS-n zugeführt.

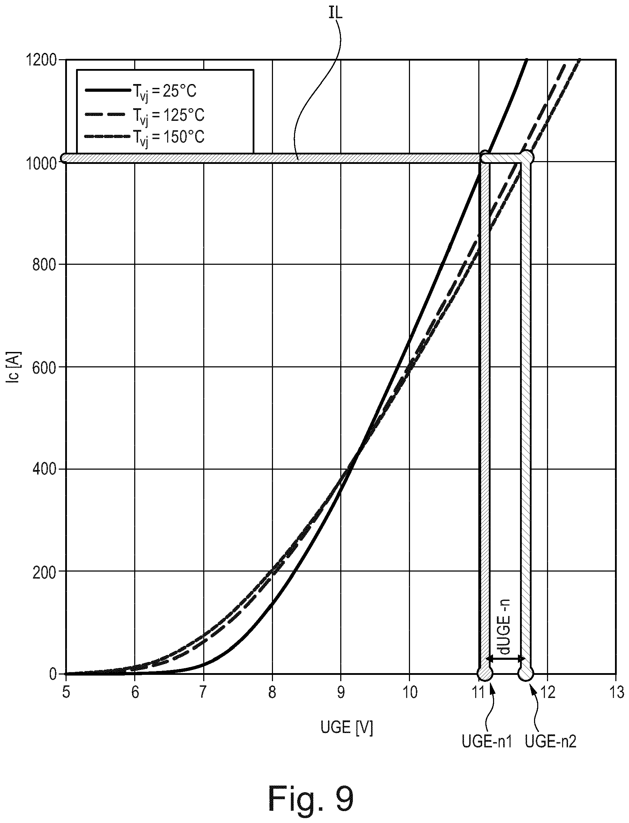

Zum Anpassungsnetzwerk T sei folgendes angemerkt. Die Schaltelemente TS-n der einzelnen Schaltstufen sind durch ihre Positionen auf einem Schaltungsträger im Betriebsfall unterschiedlichen Temperaturen ausgesetzt. Die unterschiedlichen Temperaturen führen zu dem Effekt, dass die Steuerspannung des Halbleiterschalters TSn sich verschiebt. Dies ist schematisch in der Figur 9 illustriert, die die typische Transfercharakteristik eines IGBTs als Beispiel für den Halbleiterschalter darstellt. Um den gleichen Strom IL durch den Halbleiterschalter von 1000 A erreichen zu können, ist bei 25 °C eine Steuerspannung UGE an der Gate-Emitterkapazität von 11V erforderlich, während bei einer Temperatur von 150°C die Steuerspannung UGE bei 11,7V liegen muss. Die diesbezügliche Spannungsdifferenz ist als dUGE-n bezeichnet, wobei die Spannungsdifferenz dUGE-n die Differenz zweier Steuerspannungen UGE-n1 und UGE-n2 an Schaltelementen zweier unterschiedlicher Schaltstufen n1, n2 ist. Die Spannung UGE-n ist stufenindividuell.

Es wird darauf hingewiesen, dass die Spannung UGE an der Gate-Emitterkapazität nicht springen kann. Sie wird sich immer nach einer Zeitkonstanten aufbauen, bis der Eingangswert sich einstellt. Um der Anforderung aus der Figur 9 gerecht zu werden, wird die Spannung Ue-n, die der Printtransformator TPr-n bereitstellt, im Anpassnetzwerk T zu UT-n angepasst, so dass stufenindividuell (angepasst an die vorliegende Temperatur) mit UT-n die notwenige Gate-Emitterspannung UGE-n am Steueranschluss G des Halbleiterschalters TS-n bereitgestellt wird.

Dies illustriert die Figur 10, die die Einschaltdauer t des Halbleiterschalters TS-n in Abhängigkeit von der Spannung UT-n für zwei Schaltstufen mit Spannungen UGE-n1, UGE-n2, UT-n1 und UT-n2 darstellt. Dabei gibt t0 den Zeitpunkt an, zudem der Halbleiterschalter anfängt zu leiten. tE gibt den Zeitpunkt an, wenn der Spitzenstrom IL durch den Halbleiterschalter erreicht ist. Der Stromverlauf kann auch als Impulsstrom bezeichnet werden, der durch einen steilen Anstieg und den Spitzenstrom charakterisiert ist.

Die notwendige Spannungsdifferenz für UGE-n2 bei höheren Temperaturen für den gleichen Strom ist durch erhöhte Spannung UT-n2 insoweit kompensiert, dass sie in der gleichen Schnelligkeit t0 vorliegt. Die Hochpräzision des Schaltens ist dadurch gewährleistet: UGE-n2 @ 125° strebt einen höheren End-Wert UT-n2 @ 125°C an als UGE-n1 @ 25°C gegen UT-n1 @25°C. Es wird somit durch das Anpassnetzwerk T der Eingangswert UT-n auf dem Energiespeicher CT-n mit der Temperatur angepasst, so dass der notwendige UGE-n-Wert nach dem Triggersignal sich in gleich langer Zeit t0 einstellt. Damit wird garantiert, dass zum gleichen Zeitpunkt t0 der Stromanstieg startet und zum Zeitpunkt tE der Spitzenstrom IL (z. B. 1kA) auch sicher erreicht wird.

Die Figur 11 zeigt ein Ausführungsbeispiel für ein solches Anpassungsnetzwerk T. Dabei ist auf der rechten Seite der Figur 11 ein Gate-Ersatzschaltbild des Halbleiterschalters TSn dargestellt, das einen Kondensator CGE-n und einen Widerstand RGE-n umfasst. RGE-n kann dabei ein gegenständliches Bauteil sein oder lediglich den Aufbauwiderstand repräsentieren. Bei dem Kondensator CGE-n liegt die Spannung UGE-n an.

Die linke Seite der Figur 11 zeigt das eigentliche Anpassnetzwerk T, das die Spannung Ue-n (bereitgestellt durch die Sekundärwicklung sek des Transformators TPr-n) zu einer Spannung UT-n ändert und Ue-n insofern anpasst. Die Spannung Ue-n liegt dabei über den Energiezwischenspeicher Ce-n an dem Anpassnetzwerk T an.

Das Anpassnetzwerk T umfasst eine Z-Diode D3-n, einen temperaturabhängigen Widerstand PTC1-n, den Energiespeicher CT-n und zwei Widerstände R4-n, R5-n. Am Ausgang des Anpassungsnetzwerks wird die Spannung UT-n für das Gate des Halbleiterschalters TS-n bereitgestellt. Der Energietransfer-Schalter Se-n verbindet die Baugruppe mit dem Energiespeicher der Treiberbaugruppe CT-n, während der Halbleiterschalter TS-n sperrt. Die Z-Diode D3-n ist in Sperrrichtung geschaltet und dient als Stabilisierungselement.

Die Funktionsweise der Schaltung ist derart, dass der Widerstand des temperaturabhängigen Widerstands PTC1-n mit der Temperatur ansteigt, so dass der Spannungsabfall an PTC-1 zunimmt und mit zunehmender Temperatur immer weniger Strom durch PTC1-n fließt. Damit fließt mit zunehmender Temperatur auch immer weniger Strom durch den Widerstand R5-n, so dass immer weniger Spannung an R5-n abfällt. Die Spannung UT-n ist gleich der Spannung Ue-n minus der an den Widerständen R5-n und R4-n abfallenden Spannungen. Mit bei zunehmender Temperatur geringerem Spannungsabfall an R5-n steigt somit die Spannung an UT-n mit zunehmender Temperatur.

Alternativ kann statt des PTC1-n ein temperaturabhängiger Widerstand mit negativem Temperaturkoeffizienten eingesetzt werden, für welchen Fall der Widerstand mit der Temperatur abnimmt und mit abnehmender Temperatur immer mehr Strom durch R5-n fließt. Die Spannung, auf die sich der Energiespeicher CT-n auflädt, nimmt dann mit steigender Temperatur ab.

Zusammenfassend wird durch das Anpassungsnetzwerk T die Spannung am Steueranschluss G des Halbleiterschalters TS-n nachgeführt, so dass auch bei unterschiedlichen Temperaturen der Halbleiterschalter TS-n unterschiedlicher Stufen 10 diese exakt zum gleichen Zeitpunkt eingeschaltet werden und den gleichen Strom bereitstellen.

Dabei ist vorgesehen, dass das Anpassnetzwerk T quasi der gleichen Temperatur ausgesetzt ist, wie der Halbleiterschalter TS-n. Das geschieht durch eine räumliche Nähe der Beschaltungselemente des Anpassungsnetzwerks zum Halbleiterschalter TS-n. Die Beschaltungselemente (Widerstände, Transistoren und Dioden) sind vorzugsweise auf einer Dickschichtkeramik (wegen guter Wärmeleitfähigkeit und gleichzeitiger elektrischer Isolation) realisiert. Diese Transistoren und Dioden sind als Dies ausgeführt und die Widerstände durch die Dickschichttechnologie werden direkt auf dem Schaltungsträger ausgestaltet. Damit sind auch die thermischen Übergangswiderstände auf ein Minimum reduziert, so dass der erzielte Effekt maximal ist.

Die Figur 4 zeigt eine Schaltstufe 10, bei der die in der Symmetrisierkapazität gespeicherte Energie über eine kapazitive Kopplung an den Energiezwischenspeicher Ce-n übertragen wird. Ansonsten bestehen keine Unterschiede zur Schaltstufe 10 der Figur 2, so dass ergänzend auf die Erläuterungen zur Figur 2 verwiesen wird. Insbesondere ist wiederum ein Anpassnetzwerk T vorgesehen.

Im Vergleich zur Figur 2 existieren pro Stufe jeweils zwei Hilfskapazitäten CH1-n, CH2-n, eine Hilfsinduktivität LH-n und eine Hilfs-Diode DH-n. Die Kapazitäten stehen im Verhältnis CH1-n:CSym-n beispielsweise 1:10 (in jedem Fall ist das Verhältnis kleiner als 1) und CH1-n=CH2-n. Die Hilfskapazität CH1-n wird in der Entladephase der Symmetrisierkapazität CSym-n (während der Einschaltphase des Halbleiterschalters TS-n) durch den Strom Ient-n negativ in Bezug auf Pn auf 1/10 der Stufenspannung jeweils aufgeladen. Die Kapazität CH2-n wird positiv aufgeladen und diese Ladung wird über die Schottky-Diode DS-n, in den Energiezwischenspeicher Ce-n der Treiberbaugruppe 11 transportiert und dort zwischengespeichert. Während der Sperrphase vom Schaltelement TS-n wird über den geschlossenen Energietransfer-Schalter Se-n die Energie vom Energiezwischenspeicher Ce-n in den Energiespeicher der Treiberbaugruppe CT-n transferiert.

Dabei ist die Kapazität CH2-n in der Einschaltphase des Halbleiterschalters TS-n parallel zur Kapazität CH1-n. Über die Diode DS-n ist der positive Pol von CH2-n mit dem Anpassungsnetzwerk T verbunden, das aus der zugeführten Spannung die Spannung UTn für den Energiespeicher CT-n passend zur Temperatur erzeugt. Auf diese Spannung UTn wird CT-n aufgeladen, wenn Se-n geschlossen ist, während das Schaltelement TS-n sperrt. So kann die Ladung zusätzlich aus CSym-n auf CT-n fließen. Die Hilfskapazität CH2-n stellt dabei ein kapazitives Koppelglied dar, aus dem die positive Spannung Ue-n erzeugt wird. Diese Spannung wird - nach Zwischenspeicherung im Energiezwischenspeicher Ce-n - durch das Anpassungsnetzwerk T in die positive Spannung UT-n umgewandelt.

Im Einzelnen: Während der Sperrphase ist CH1-n über LH-n kurzgeschlossen. Wenn der Halbleiterschalter TS-n eingeschaltet wird, so wird über die Diode DH-n die Kapazität CH2-n parallel zur Kapazität CH1-n geschaltet. An der Induktivität LH-n wird eine Spannung induziert. Auf diese Spannung werden alle drei Elemente CH1-n, CH2-n und LH-n geladen. Die Diode DH-n verhindert das Entladen der Kapazität CH2-n direkt nach Emitter. Der eingezeichnete Pfad über DS-n ermöglicht aber die Energieabgabe an den Energiezwischenspeicher Ce-n während dieser Phase. Während der Sperrphase vom Halbleiterschalter TS-n kann diese zwischengespeicherte Energie über das Anpassnetzwerk T, in dem die thermische Anpassung der Spannung auf UT-n stattfindet, an den Energiespeicher CT-n weitergegeben werden. Der Energiespeicher CT-n wird dabei auf die Spannung UT-n aufgeladen. Die wirksame Kapazität pro Stufe ist somit CSym-n vor dem Einschalten. Die Diode D1-n ist notwendig, damit die auf den Zwischenspeicher Ce-n aufgebrachte Initial-Ladung sich nicht gleich über R2-n wieder entladen kann.

Die Figur 5 zeigt eine weitere Ausgestaltung der Schaltstufe, bei der die in der Symmetrisierkapazität gespeicherte Energie über eine kapazitive Kopplung an den Energiezwischenspeicher Ce-n übertragen wird. Dabei wird die Kapazität CH1-n auf 10% der Stufenspannung negativ aufgeladen. Die Energie wird über die Spule LH-n in eine negative Treiberstromversorgung umgeladen.

Dabei ist zu berücksichtigen, dass eine negative Initialspannung in Bezug auf Pn aus dem Symmetrisierkreis bereitgestellt werden muss. Deshalb wird im Unterschied zu den Figuren 2 und 4 noch ein Widerstand R3-n in der Figur 5 ergänzt. Er übernimmt diese Aufgabe.

In beiden Ausgestaltungen der Figuren 4 und 5 stellt die Hilfskapazität CH1-n eine Koppelkapazität dar, die in Reihe mit der Symmetrisierkapazität CSym-n geschaltet ist, wobei die Koppelkapazität sich über die Spule LH-n entladen kann, und wobei die Koppelkapazität CH1-n über die Spule LH-n und die Diode DS-n Energie an den Energiespeicher CT-n der Treiberbaugruppe 11 überträgt. Die ablaufenden Vorgänge sind hier die gleichen wie für Figur 4 schon beschrieben. Die Figur 5 zeigt dabei beispielhaft, wie die negative Versorgungsspannung zusätzlich für den Energiezwischenspeicher Ce-n und nachfolgend für den Energiespeicher der Treiberbaugruppe CT-n bereitgestellt werden kann. Die Energie dafür wird kapazitiv mit CH1-n und entsprechender Beschaltung mit DSn realisiert. Die Diode D1-n ist notwendig, damit die auf den Zwischenspeicher Ce-n aufgebrachte Initial-Ladung sich nicht gleich über R3-n wieder entladen kann.

Im Folgenden wird unter Bezugnahme auf die Figur 6 erläutert, wie das Trigger-Signal für die Schalter T1-n, T2-n der Figuren 1, 2, 4, 5 hochpräzise optisch übertragen werden kann. Dabei wird darauf hingewiesen, dass die optische Erzeugung des Trigger-Signals unabhängig von der konkreten Ausführung des Hochleistungsschaltmoduls 1 erfolgen kann. Die optische Erzeugung des Triggersignals kann somit auch bei Hochleistungsschaltmodulen erfolgen, die in anderer Weise als in den Figuren 1-5 dargestellt ausgebildet sind, jedoch naturgemäß stets einen Energiespeicher der Treiberbaugruppe und einen Halbleiterschalter aufweisen.

Es ist vorgesehen, dass dem Hochleistungsschaltmodul 1 ein optisches Triggernetzwerk 20 zugeordnet ist, das mit den Treibernetzwerken der einzelnen Schaltstufen 10 optisch gekoppelt ist, um die Schaltstufen 10 gleichzeitig zu schalten. Elektrisch sind die Netzwerke getrennt. Das optische Triggernetzwerk 20 weist eine Mehrzahl von lichtemittierenden Elementen LED1-n auf, die beispielsweise als Leuchtdioden, jedoch auch in anderer Weise, beispielsweise als VCSEL ausgebildet sein können. Die lichtemittierenden Elemente sind dabei jeweils Bestandteil einer Teilschaltung 21, die neben dem jeweiligen lichtemittierenden Element LED1-n eine Stromversorgung IA sowie eine Kapazität C2-n aufweist.

Dabei ist vorgesehen, dass das lichtemittierende Element LED1-n jeder Stufe stufenindividuell durch den Strom IA im Arbeitspunkt durchflossen wird. Der Strom IA bewirkt, dass das lichtemittierende Element LED1-n einen kleinen Basis-Lichtstrom aussendet. Durch die Entladung der Kapazität C2-n wird ein Zusatzstrom dl bereitgestellt. In Abhängigkeit von der Richtung des Zusatzstroms dl (dl kann sowohl positiv als auch negativ sein) wird der Strom durch das lichtemittierende Element LED-n erhöht oder reduziert. Dies dazu führt, dass das lichtemittierende Element LED1-n von dem Zustand, in dem es den kleinen Basis-Lichtstrom aussendet, in einen Zustand wechselt, in dem es einen höheren Lichtstrom aussendet oder einen niedrigeren Lichtstrom aussendet, wobei der höhere Lichtstrom dem Signal "High" und der niedrigere Lichtstrom dem Signal "Low" entspricht.

Die Entladung der Kapazität C2-n (in positiver oder negativer Richtung) sämtlicher Stufen wird durch eine Steuereinrichtung getriggert, die in der Figur 1 als Steuereinrichtung 15 dargestellt ist.

Das optische Triggernetzwerk 20 ist über eine optische Kopplung 70 mit einem optischen Triggerarray 30 gekoppelt, welches eine Mehrzahl von lichtdetektierenden Elementen LD1-n aufweist, wobei jeweils ein lichtemittierendes Element LED1-n einem lichtdetektierenden Element LD1-n zugeordnet ist. Die optische Kopplung 70 kann beispielsweise über eine freie Übertragungsstrecke, durch eine Kunststoffscheibe oder über einen Lichtwellenleiter erfolgen. Das lichtdetektierende Element ist beispielsweise als Fotodiode ausgebildet.

Die lichtdetektierenden Elemente LD1-n empfangen entweder einen niedrigen Lichtstrom (Low-Signal) oder einen hohen Lichtstrom (High-Signal). Davon abhängig wird die Treiberschaltung 11 geschaltet. Hierzu ist jeweils eine Teilschaltung 310 vorgesehen, die einen Widerstand RA-n umfasst, der in Reihe mit dem lichtdetektierenden Element LD1-n geschaltet ist und dessen Arbeitspunkt einstellt. Weiter umfasst die Teilschaltung 310 einen Komparator 35 in Form beispielsweise eines Operationsverstärkers (entsprechend dem Komparator 35 der Figuren 1, 2, 4, 5) sowie eine Kapazität C1-n und zwei Widerstände R1-n, R2-n. Dabei liegt das lichtdetektierende Element LD1-n über die Kapazität C1-n und den Widerstand R1-n an dem einen Eingang des Komparators 35 an. Der andere Eingang des Komparators ist nur über den Widerstand R2-n mit dem lichtdetektierenden Elemente LD1-n verbunden.

Die Wirkungsweise der Schaltung ist wie folgt. Der eine Eingang des Komparators 35 ist durch die Kapazität C1-n mit R1-n in Reihe träger als der Eingang mit R2-n allein. Beide Eingänge haben als Referenzspannung den Spannungsabfall an LD1-n. Falls mehr Lichtstrom ankommt (größerer Strom auf der Senderseite - High-Signal), dann gibt es eine leichte Spannungserhöhung an LD1-n. Der Eingang des Komparators R2-n ist sofort höher als der Eingang an C1-n. Es gibt einen positiven Impuls am Ausgang des Komparators 35. Wenn weniger Lichtstrom empfangen wird (kleinerer Strom auf der Senderseite - Low-Signal), dann wird auch die Spannung an LD1-n kleiner. Dadurch wird der Eingang an C1-n wegen des gleichen Grundes (Trägheit des Gliedes C1-n in Reihe zu R1-n) vom Komparator größer als an R2-n. Es wird ein negativer Impuls am Ausgang des Komparators 35 erzeugt.

Diese Art der Triggerung wird auch als Flankentriggerung bezeichnet.

Abhängig davon, ob das lichtdetektierende Element LD1-n ein High-Signal oder ein Low-Signal detektiert, stellt der Ausgang des Komparators 35 die positive Spannung + oder die negative Spannung -, die an seinen Versorgungsleitungen 351, 352 anliegt, bereit. Diese Ausgangsspannung des Komparators 35 steuert die Gate-Anschlüsse der komplementär aufgebauten Transistoren bzw. Schalter T1-n, T2-n. Der Komparator 35 stellt dabei nur einen positiven Impuls oder einen negativen Impuls bereit. Die Gate-Signale von den Schaltern T1-n bzw. T2-n können vom Betrag her sich im Bereich von beispielswese 5V bis 20V bewegen. Die Versorgung des Komparators 35 erfolgt durch den Dualsperrwandler ICSp-n (siehe Figuren 2, 4, 5), dessen Eingang von einem Teil des Symmetriestroms versorgt wird. Der Eingang des Dualsperrwandlers ICSp-n in jeder Stufe liegt parallel zum Energiezwischenspeicher Ce-n, der immer mindestens durch einen Teilstrom vom Symmetriestrom aufgeladen ist.

Der Energiespeicher CT-n der Figuren 1, 2, 4, 5 entlädt sich dabei über den Transistor T1-n, wenn dieser leitet, und sein Spannungsniveau definiert für diesen Fall die Spannung am Steueranschluss G des Halbleiterschalters TS-n. Dabei werden mit einer positiven Spannung T1-n und damit TS-n eingeschaltet und wird mit einer negativen Spannung T2-n eingeschaltet und damit TS-n ausgeschaltet. Die Logik ist alternativ natürlich auch umkehrbar gestaltbar, d.h. mit negativer Spannung kann TS-n eingeschaltet und mit positiver Spannung kann TS-n ausgeschaltet werden (wobei in einem solchen Fall ein Schaltelement TS-n verwendet wird, bei dem der Sinn der Polarität für "ein" und "aus" umgekehrt ist).

Das gleiche Steuersignal vom Komparator 35, welches den Transistor T2-n einschaltet und damit den Halbleiterschalter TS-n ausschaltet, bringt den Energietransfer-Schalter Se-n in den Zustand geschlossen bzw. "ein". Dabei gilt, dass der Energietransfer-Schalter Se-n ein "normally closed" Schalter ist, d.h. er ist immer geschlossen bis auf den Augenblick, wo der Halbleiterschalter TS-n eingeschaltet wird. Das Öffnen des Energietransfer-Schalters Se-n erfolgt über den gleichen Steuerimpuls, der T1-n ansteuert und den Halbleiterschalter TS-n einschaltet, so dass über den Energietransfer-Schalter Se-n kein Strom fließt, wenn der Energiezwischenspeicher Ce-n über die Symmetrisierkapazität CSym-n aufgeladen wird. Der einzige Unterschied besteht darin, dass der Steuerimpuls, der den Energietransfer-Schalter Se-n öffnet, den Schalter T1-n schließt.

Die Fig. 6a zeigt ein weiteres Ausführungsbeispiel einer optischen Triggerung. Das Ausführungsbeispiel der Figur 6a weist ein optisches Triggernetzwerk 20 auf, das in gleicher Weise wie bei der Figur 6 ausgebildet ist, so dass auf die dortigen Ausführungen hingewiesen wird. Der Unterschied zum Ausführungsbeispiel der Figur 6 besteht darin, dass das optische Triggerarray 30 eine in anderer Weise ausgebildete Teilschaltung 320 zum Schalten des Komparators 35 aufweist. So ist vorgesehen, dass der eine, erste Eingang + des Komparators 35 mit einer festen Referenzspannung beaufschlagt wird, die über ein Potentiometer P1 einstellbar ist. Der andere, zweite Eingang - des Komparators 35 wird mit der an dem lichtdetektierenden Element LD1-n anliegenden Spannung beaufschlagt und ist dementsprechend veränderlich. Je nachdem, ob die veränderliche Spannung am zweiten Eingang größer oder kleiner als die feste Spannung am ersten Eingang ist, wird am Ausgang des Komparators 35 eine positive Spannung + oder eine negative Spannung - bereitgestellt, die an den Gate-Anschlüssen der Schalter T1-n, T2-n anliegt.

Diese Art der Triggerung wird auch als Schwellentriggerung bezeichnet.

Mit dem optischen Triggernetzwerk 20 werden folgende Anforderungen mindestens erreicht:

- Per optische Übertragungsstrecke wird erreicht, dass die Treiberbaugruppen 11 synchron mit Pikosekunden-Unterschied ihre Energie abgeben und sämtliche Schaltstufen ein- und ausgeschaltet werden.
- Die lichtemittierenden Elemente LED1-n und die lichtdetektierenden Elemente LD1-n sind aufeinander abgestimmt.
- Es erfolgt eine hochpräzise Übertragung mit einem Jitter kleiner als 200ps der Vorder- und Rückflanke eines Triggerimpulses.

Die Figur 6 zeigt auch die Kennlinie KL1 des lichtemittierenden Elements LED1-n und die Kennlinie KL2 des lichtdetektierenden Elements LD1-n (wobei diese Kennlinien sowohl für die optische Triggerung gemäß Figur 6 als auch für die optische Triggerung gemäß Figur 6a gelten). Sowohl das lichtemittierende Element als auch das lichtdetektierende Element werden jeweils in dem linearen Bereich der Kennlinie betrieben, in dem der Strom (mA) bzw. der Lichtstrom (Lm) und die Spannung (U/V) annähernd linear verknüpft sind. Dies ist mit dem Vorteil verbunden, dass Zeitverschiebungen, die durch ein Umladen der Sperrschichtkapazität und thermische Effekte beim Halbleiterübergang von "nicht leitend" nach "leitend" entstehen, vermieden werden. Der lineare Bereich der Kennlinien KL1, KL2 ist in der Figur 6 oben rechts vergrößert dargestellt.

Über die Kapazität C2-n wird wie beschrieben in allen Teilschaltungen 21 in gleicher Weise ein Zusatzstrom dl geliefert. Durch den Zusatzstrom dl detektieren die Empfangsdioden LD1-n nun einen High-Zustand, wenn dl positiv ist und einen Low-Zustand, wenn dl negativ ist.

Dabei kommt im jeweiligen Treiberkreis 11 stufenindividuell ausreichend Licht für jede Empfangsdiode LD an. Auf der Empfängerseite setzt der Komparator 35 den empfangenen Lichtstrom in elektrische Pegel um. Die Energiespeicher CT-n der Treiberbaugruppe geben ihre Energie ab, ausgelöst durch den von der Empfangsdiode LD1-n detektieren High-Zustand, gleich schnell und quasi sofort, nämlich mit lediglich einer Differenz im Pikosekunden-Bereich, an die Steueranschlüsse bzw. Gate-Anschlüsse der jeweiligen Halbleiterschalter TS-n ab.

Die erfindungsgemäße optische Triggerung reduziert in erheblichem Maße Verzögerungen, die bei einem elektrischen Triggern auftreten würden und vermeidet darüber hinaus weitgehend Temperatureffekte. Der Schaltvorgang kann dementsprechend sehr genau definiert werden.

Zurückkommend auf die Figuren 1 bis 5 wird noch darauf hingewiesen, dass im Wesentlichen keine Phasenverschiebung zwischen dem induzierten Strom im Sekundärkreis sek und dem Strom im Primärkreis pr vorliegt, so dass eine Energieübertragung zwischen dem Primärkreis pr und dem Sekundärkreis sek im Wesentlichen ohne zeitliche Verzögerung erfolgt. Der Energiezwischenspeicher wird somit bereits während der Einschaltphase des Halbleiterschalters durch die Energie der Symmetrisierkapazität aufgeladen. Der Energiezwischenspeicher gibt die zwischengespeicherte Energie an den Energiespeicher der Treiberbaugruppe im Sperrzustand des Halbleiterschalters für die nachfolgenden Einschaltvorgänge weiter.

Die Figur 7 zeigt ein Ausführungsbeispiel der Ausgestaltung des Halbleiterschalters TS-n und der zugeordneten Leitungsebenen, wobei zwei Halbleiterschalter unterschiedlicher Schaltstufen auf dem gleichen Substrat 36 nebeneinander angeordnet sind. Der Halbleiterschalter TS-n ist jeweils in Form eines ungehäusten Halbleiter-Dies 31, auch als Nacktchip bezeichnet, ausgebildet. Der Halbleiter-Die 31 weist eine plane Oberseite und eine plane Unterseite auf. Die plane Oberseite bildet den Emitter-Anschluss und die plane Unterseite den Kollektor-Anschluss. Die plane Unterseite des Halbleiter-Dies 31 ist auf einer planen ersten Leitebene 32 angeordnet, so dass der Kollektor-Anschluss über die Leitebene 32 kontaktiert wird.

Unterhalb der ersten Leitebene 32 befindet sich eine plane zweite Leitebene 33. Die beiden Leitebenen 32, 33 sind dabei durch eine Isolationsschicht 34 voneinander getrennt, die sich zwischen den beiden Leitebenen 32, 33 erstreckt. Der Abstand zwischen den beiden Leitebenen 32, 33 bzw. die Dicke der Isolationsschicht 34 beträgt dabei weniger als 100 $\mu$m und liegt beispielsweise bei 50 $\mu$m.

Wie dargestellt, sind die Leitebenen 32, 33 dabei mit einem kleinen Versatz ausgeführt. Dieser ist vorteilhaft, um die Verbindungen der Stufen untereinander zu realisieren.

Die Kontaktierung der Oberseite bzw. des Emitter-Anschlusses des Halbleiter-Dies 31 erfolgt über zwei flache Kupferbügel 37, die sich von der zweiten Leitebene 33 auf die Oberseite des Halbleiter-Dies 31 erstrecken. Der Kollektor-Anschluss des Halbleiter-Dies 31 wird durch die erste Leitebene 32 bereitgestellt.

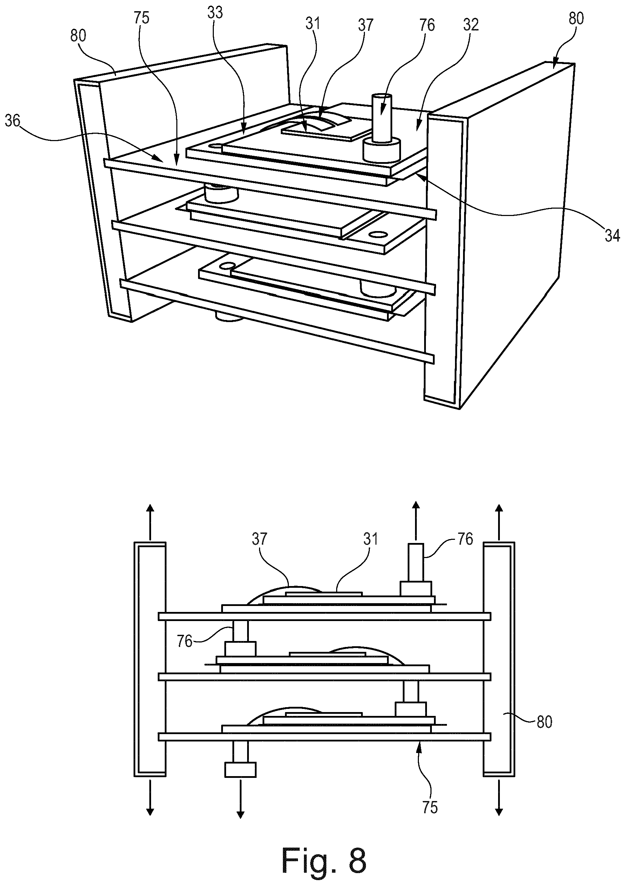

Die Leitebenen 32, 33 stellen Ausführungsbeispiele der in der Figur 1 dargestellten Leitungen 16 dar, die die einzelnen Schaltstufen verbinden. Dabei bildet der Kollektor der einen Leitebene den Emitter der nächsthöheren Schaltstufe, wie sich auch aus der Figur 8 ergibt, auf die noch eingegangen wird.

Wie der unteren Darstellung der Figur 7 entnommen werden kann, kann vorgesehen sein, dass das in Bezug auf die Figuren 1, 2, 4 und 5 beschriebene Anpassnetzwerk T direkt unter dem jeweiligen Schaltelement TS-n angeordnet ist, so dass die jeweiligen Komponenten der gleichen Temperatur ausgesetzt sind.

Die Gesamtanordnung ist auf einem keramischen Substrat 36 angeordnet.

Der beschriebene Aufbau ermöglicht die Reduzierung der Aufbau-Induktivität in jeder Stufe, wie nachfolgend im Einzelnen ausgeführt wird. Ziel dabei ist es, einen schnellstmöglichen Schaltvorgang des Halbleiterschalters TS-n zu realisieren. Die bereitgestellte Lösung gemäß der Figur 7 beruht auf dem Gedanken, den Strompfad derart aufzubauen, dass die den Schaltvorgang abbremsende Induktivität durch die unmittelbare Nähe der Magnetfelder von Vorwärts- und Rückstrom kompensiert wird. Das so reduzierte Magnetfeld bremst den Schaltvorgang in nur reduziertem Maße ab. Dies erhöht auch die Synchronität und erreichbare Schaltfrequenz (zum Beispiel 10 kHz) der einzelnen Schaltstufen, sodass eine höhere Stufenanzahl und Schalter für noch höhere Spannungen realisierbar sind. Dabei können Hochspannungen im Bereich bis zu 30kV realisiert werden.

Die mit der Anordnung der Figur 7 verbundenen Vorteile werden nachfolgend anhand eines Zahlenbeispiels erläutert.

Es wird ausgegangen von der empirischen Gesetzmäßigkeit (aus F.W.Grover: "Inductance calculations: working formulas and tables", Instrument society of America 1973, ISBN 0-87664-557-0):

$$L \approx 0{,}004 * l * \pi * \frac{d}{B} \; in \; uH^{*}$$

mit

    l: Länge der Leiter in cm
    d: Abstand der Leiter zueinander in cm
    B: Breite der Leiter in cm

Anhand von einer Schaltstufe wird erklärt, wie sich die Induktivität der Schaltstufen bei einem Aufbau gemäß der Figur 7 verkleinert. Bei der Erklärung wird eine positive Stromrichtung (für diesen Spezialfall von Kollektor zum Emitter) angenommen. Als Halbleiterschalter TS-n wird beispielsweise ein IGBT angenommen.

Die Strom-Leitebenen 32, 33 für den Kollektor und den Emitter sind gemäß der Figur 7 als große übereinaderangeordnete Flächen ausgeführt, die in einem kleinstmöglichen Abstand zueinander angeordnet sind. Wegen der notwendigen Isolationsfestigkeit (U≥1,7kV) muss zwischen den beiden Flächen für ausreichende Isolation durch die Isolationsschicht 34 gesorgt werden. Das Anordnen der Strom-Leitebenen 32, 33 übereinander sorgt für ein kurzes Rückfließen des gleichen Stromes, der über den Kollektor in die Stufe hineinfließt und über den Emitter ab-/weiterfließt. Es gilt mit der oben genannten Formel bei l=1,6 cm, B=2,8 cm und d=50 μm beispielsweise:

$$L_{ST} \approx 0,004\frac{\mu H}{cm} * 1,6cm * \pi * \frac{50*10^{-4}cm}{2,8cm} \approx 36\text{pH}$$

Dieses Rechenbeispiel zeigt auf, dass die Induktivität pro Stufe durch den beschriebenen Aufbau nahezu komplett aufgehoben ist.

Ein weiterer, mit der Schaltung der Figur 7 verbundener Vorteil besteht darin, dass ansonsten übliche Bonddrähte durch flache, breite Kupferbügel 37 ersetzt sind. Der Einsatz solcher Bügel 37 kann dabei unabhängig von dem konkreten, implementierten Aufbau des Halbleiterschalters TS-n erfolgen. Die Kupferbügel 37 sind als flache, breite Bleche ausgebildet, d. h. Breite und Länge der Kupferbügel 37 sind größer als dessen Dicke. Zusätzlich zum Emitter-Anschluss kann auch der Steueranschluss (Gate-Anschluss) über Kupferbügel realisiert sein (nicht dargestellt).

Die Verwendung breiter Kupferbügel anstatt von Bond-Drähten führt zu einer reduzierten parasitären Induktivität und insbesondere zu einer verbesserten Entwärmung des Bauteils. Um dies zu illustrieren, wird nachfolgend die klassische Variante der Gate-Emitter-Kontaktierung mit Bonddrähten anhand von Berechnungen mit der Verbindungstechnik unter Verwendung von breiten Kupferbügel in Bezug auf parasitäre Induktivität und thermischen Widerstand verglichen.

Die Berechnungen werden mit den nachfolgenden Formeln für jeden Last-Emitter-Kreis durchgeführt (wobei analoge Berechnungen für den Gate-Kreis möglich sind). Dabei wird nur die Emitter-Kontaktierung vom Halbleiter-Die 31 an die zugehörige Leitebene 33 auf dem Keramiksubstrat 36 betrachtet. Der Kupferbügel 37 kann zur Vereinfachung als Flachleiter angenommen werden. Die empirische Formel für die Induktivität $L_F$ von einem Flachleiter lässt sich wie folgt angeben.

$$L_F = 0,002 * l * \left( \ln\left(\frac{2*l}{B+C}\right) + 0,5 \right) \ in \ uH$$

Für die betrachteten Kupferbügel 37 gilt beispielhaft:

l=0,8cm: Länge des Leiters in cm
B=0,5cm: Breite des Leiters in cm
C=0,3cm: Dicke/Höhe des Leiters in cm

Die Kontaktierung besteht aus zwei solchen Flachleitern 37. Das führt insgesamt zur Halbierung der berechneten Induktivität $L_F$. Somit ist die Emitter-Anschlussinduktivität $L_{SEB}$ mit zwei Kupferbügeln wie folgt:

$$L_{SEB} = \frac{L_F}{2} \approx 954pH$$

Dem wird die parasitäre Induktivität eines Bonddrahtes gegenübergestellt. Die parasitäre Induktivität eines Bonddrahts $L_{BD}$ lässt sich vereinfacht als die Induktivität eines Leiters mit einem Kreisquerschnitt annähern.

$$L_{BD} = 0,002 * l * \left( \ln\left(\frac{2*l}{r}\right) - 0,75 \right) \ in \ \mu H$$

Es gilt beispielsweise typischerweise:

l=1cm: Länge des Leiters in cm
r=0,02cm: Radius des Leiters

Die Kontaktierung besteht typischerweise aus 8 solchen Bonddrähten. Deshalb wird die berechnete Induktivität $L_{BD}$ durch 8 geteilt, um die Emitter-Anschlussinduktivität mit acht Bond-Drähten $L_{SBD}$ auszurechnen.

$$L_{SBD} = \frac{L_{BD}}{8} \approx 964 pH$$

Es zeigt sich somit eine leicht reduzierte parasitäre Induktivität bei der Verwendung zweier breiter Kupferbügel anstatt der Verwendung von acht Bonddrähten.

Die Kontaktierung führt jedoch zu einer deutlich erhöhten Wärmeableitung in das Keramiksubstrat 36. Um dies aufzuzeigen, wird im Folgenden der thermische Widerstand von beiden Aufbauvarianten miteinander verglichen. Es gilt für die Verlustleistung, die vom Halbleiter-Die 31 zur Leitebene 33 auf dem Substrat 36 abgeführt wird:

$$R_{th} = \frac{l}{\lambda * A}$$

Dabei sind

$\lambda$: die Wärmeleitfähigkeit. Für Aluminium gilt: $\lambda_{Al}$ = 236W/mK. Für Kupfer gilt: $\lambda_{Cu}$ = 380W/mK
I: die Länge des Materials, durch welches die Verlustleistung fließt. Für den Bügel gilt: $l_B$ = 0,008m. Für den Bonddraht gilt: $l_D$=0,01m
A: der Querschnitt, durch den die Verlustleistung fließt. Für zwei Bügel gilt: $A_B$=2*C*B=2*0,005m*0,003m=3*10$^{-5}$m$^2$ mit C=Höhe des Bügels und B=Breite des Bügels. Für acht Bonddrähte gilt: $A_D$=8*$\pi$*r$^2$=8*$\pi$*(0,0002m)$^2 \approx$1,005*10$^{-6}$m$^2$ mit r=Radius von einem Bonddraht.

Damit gilt für die Verlustleistung bei einer Bügel-Verbindung und bei einer Bond-Verbindung:

$$R_{thB} = \frac{0,008m*m*K}{380W*3*10^{-5}m*m} \approx 0,7\frac{K}{W} \text{ (thermischer Widerstand der Bügel Verbindung)}$$

$$R_{thBD} = \frac{0,01*m*m*K}{236W*1,005*10^{-6}m*m} \approx 42\frac{K}{W} \text{ (thermischer Widerstand der Verbindung beim Bonden)}$$

Aus der Rechnung folgt: durch die Bonddrähte wird die Verlustleistung schlechter abgeführt. Dagegen werden mittels einer Bügel-Verbindung die Verluste um den Faktor 60 besser vom Die abgeleitet. Wegen des robusteren Aufbaus mit Bügeln sind auch auflötbare Kühlkörper auf der Emitterseite möglich. Des Weiteren ist eine verbesserte Wärmeabfuhr vom Die schon bereits wegen der nach oben vergrößerter Oberfläche des Bügels auch ohne Kühlkörper gegeben.

Zusammenfassend ist festzustellen, dass Kupferbügel eine Verkleinerung der parasitären Induktivität ermöglichen. Im Vergleich zu Bonddrähten wird dabei eine geringere Anzahl von Bonddrähten benötigt. Dies bringt insbesondere Vorteile bei Anwendungen mit einem hohen und steilen Stromimpuls. Des Weiteren ergibt sich bei der Verwendung von Kupferbügeln eine verbesserte Verlustleistungsabführung über die Oberseite und damit eine verbesserte Kühlung des Halbleiter-Dies 31, der aufgrund der Kühlung über Kupferbügel an seiner Oberseite an beiden Seiten Wärme abgeben kann. Dabei kann vorgesehen sein, dass auf dem Substrat 36 Kühlkörper angeordnet sind. Kupferbügel stellen darüber hinaus aus mechanischer Sicht eine robuste Variante bereit.

Die Figur 8 zeigt einen Stackaufbau eines Hochleistungsschaltmoduls, wobei jede Schaltstufe mit einem Aufbau gemäß der Figur 7 in einer eigenen Ebene 75 innerhalb des Stackaufbaus angeordnet ist (wobei auf einem Keramiksubstrat 36 allerdings nur ein Halbleiterschalter ausgebildet ist).

Die einzelnen Ebenen 75 sind dabei zwischen zwei Schaltungsträgerhaltern 80 mit einer EMV-Beschichtung angeordnet. Jede Ebene 75 umfasst ein Substrat 36 mit zwei Leitebenen 32, 33, zwischen denen eine Glasisolation 34 angeordnet ist, wie in Bezug auf Figur 7 beschrieben. Weiter ist der jeweilige Halbleiter-Die 31 dargestellt, der über zwei flache Kupferbügel 37, die sich von der zweiten Leitebene 33 auf die Oberseite des Halbleiter-Dies 31 erstrecken, kontaktiert wird. Versetzte lötfähige Verbindungselemente 76 dienen der elektrischen Verbindung der einzelnen Ebenen 75.

Der Stackaufbau gemäß der Figur 8 ist reparaturfreundlich, da die einzelnen Schaltstufen gesondert repariert und ausgetauscht werden können. Darüber hinaus wird der Strom über die Verbindungselemente 76 schlangenförmig hin- und her geführt, so dass sich die Magnetfelder entsprechend ändern und dabei teilweise sich gegenseitig aufheben.

**Patentansprüche**

1. Hochleistungsschaltmodul zur direkten hochpräzisen Pulsenergiespeisung eines Verbrauchers mit einer Mehrzahl in Reihe geschalteter Schaltstufen (10), wobei jede Schaltstufe (10) aufweist:

   - einen Halbleiterschalter (TS-n) mit Kollektoranschluss (C), Emitteranschluss (E) und Steueranschluss (G), der abhängig von der am Steueranschluss (G) anliegenden Spannung einen eingeschalteten Zustand, in dem zwischen dem Kollektoranschluss (C) und dem Emitteranschluss (E) ein Strom fließt, und einen ausgeschalteten Zustand, in dem zwischen dem Kollektoranschluss (C) und dem Emitteranschluss (E) kein Strom fließt, aufweist, und
   - eine auf den Halbleiterschalter (TS-n) einwirkende Treiberbaugruppe (11), wobei die Treiberbaugruppe (11) zwei Schalter (T1-n, T2-n) zur Steuerung des Steueranschlusses (G) des Halbleiterschalters (TS-n) sowie einen Energiespeicher (CT-n) aufweist, der Energie für das Einschalten des Halbleiterschalters (TS-n) bereitstellt,
   - ein optisches Triggernetzwerk (20), das mit den Treiberbaugruppen (11) der einzelnen Schaltstufen (10) optisch gekoppelt ist, um die Schaltstufen (10) gleichzeitig zu schalten, wobei das optische Triggernetzwerk (20) eine Mehrzahl von lichtemittierenden Elementen (LED1-n) aufweist, die gleichzeitig zwischen einem niedrigen emittierten Lichtstrom und einem hohen emittierten Lichtstrom umschaltbar sind, und jedem lichtemittierenden Element (LED1-n) des optischen Triggernetzwerks (20) mindestens ein lichtdetektierendes Element (LD1-n) einer Schaltstufe (10) zugeordnet ist, wobei das mindestens eine lichtdetektierende Element (LD1-n) abhängig davon, ob es einen niedrigen Lichtstrom oder einen hohen Lichtstrom empfängt, eine Änderung des Schaltzustands der Schaltstufe (10) auslöst,

   **dadurch gekennzeichnet,**
   **dass** die lichtemittierenden Elemente (LED1-n) stufenindividuell auf einen Strom im Arbeitspunkt (IA) eingestellt sind, in dem das lichtemittierende Element (LED1-n) einen Lichtstrom aussendet, wobei dem Strom im Arbeitspunkt (IA) für ein Umschalten auf einen hohen Lichtstrom oder einen niedrigen Lichtstrom ein positiver oder negativer Zusatzstrom (dl) aufgeprägt wird.

2. Hochleistungsschaltmodul nach Anspruch 1, **dadurch gekennzeichnet, dass** die lichtemittierenden Elemente (LED1-n) und/oder die lichtdetektierenden Elemente (LD1-n) mittels zugeordneter Einstellmittel derart stufenindividuell eingestellt sind, dass in dem Zustand, in dem das lichtemittierende Element (LED1-n) einen niedrigen Lichtstrom emittiert, das zugeordnete lichtdetektierende Element (LD1-n) an der Schwelle zur Detektion eines hohen Lichtstroms liegt.

3. Hochleistungsschaltmodul nach Anspruch 1 oder 2, **dadurch gekennzeichnet, dass** das optische Netzwerk (20) für jede Schaltstufe (10) den Zustand der zwei Schalter (T1-n, T2-n) steuert, die in dem Sinne komplementär arbeiten, dass der eine Schalter (T1-n) geöffnet ist, wenn der andere Schalter (T2-n) geschlossen ist, und umgekehrt, und die beiden Schaltzustände den eingeschalteten Zustand und den ausgeschalteten Zustand des Halbleiterschalters (TS-n) definieren, wobei die beiden Schalter (T1-n, T2-n) durch die Ausgangsspannung eines Komparators (OP1-n) geschaltet werden und das optische Netzwerk (20) für jede Schaltstufe (10) über den vom lichtdetektierenden Element (LD1-n) detektierten Lichtstrom den Komparator (OP1-n) steuert.

4. Hochleistungsschaltmodul nach einem der vorangehenden Ansprüche, **dadurch gekennzeichnet, dass** das Hochleistungsschaltmodul für jede Schaltstufe (10) des Weiteren einen Komparator (35) aufweist, der zwei Eingänge aufweist, wobei mindestens einem der Eingänge die veränderliche Spannung des lichtdetektierenden Elements (LD1-n) der Schaltstufe (10) zugeführt wird, und wobei abhängig davon, ob das lichtdetektierende Element (LD1-n) der Schaltstufe (10) einen niedrigen Lichtstrom oder einen hohen Lichtstrom empfängt, der Ausgang des Komparators (35) eine positive Spannung oder eine negative Spannung, die an Versorgungsleitungen (351, 352) des Komparators (35) anliegt, bereitstellt, wobei die Ausgangsspannung des Komparators (35) die Schalter (T1-n, T2-n) der jeweiligen Treiberbaugruppe (11) steuert.

5. Hochleistungsschaltmodul nach Anspruch 4, **dadurch gekennzeichnet, dass** der Komparator (35) zwei Eingänge aufweist, wobei dem einen Eingang die veränderliche Spannung des lichtdetektierenden Elements (LD1-n) der Schaltstufe (10) zugeführt und der andere Eingang mit einer Referenzspannung beaufschlagt ist.

6. Hochleistungsschaltmodul nach Anspruch 4, **dadurch gekennzeichnet, dass** der Komparator (35) zwei Eingänge aufweist, wobei dem einen Eingang die veränderliche Spannung des lichtdetektierendes Element (LD1-n) der Schaltstufe (10) über einen Widerstand (R2-n) und dem anderen Eingang die veränderliche Spannung des lichtdetektierendes Element (LD1-n) der Schaltstufe (10) über ein RC-Glied (R1-n, C1-n) zugeführt wird, wobei eine Spannungsänderung dem lichtdetektierenden Element(LD1-n) mit unterschiedlicher Trägheit den Eingängen des Komparators (35) zugeführt wird.

**7.** Hochleistungsschaltmodul nach einem der Ansprüche 4 bis 6, **dadurch gekennzeichnet, dass** der Komparator als Operationsverstärker ausgebildet ist.

**8.** Hochleistungsschaltmodul nach einem der vorangehenden Ansprüche, **dadurch gekennzeichnet, dass** für jede Schaltstufe (10) das lichtdetektierende Element (LD1-n) in Reihe mit einem Widerstand (RA-n) geschaltet ist, der den Arbeitspunkt des lichtdetektierenden Elements (LD1-n) einstellt.

**9.** Hochleistungsschaltmodul nach einem der vorangehenden Ansprüche, **dadurch gekennzeichnet, dass** das optische Triggernetzwerk (20) für jede Schaltstufe einen Kondensator (C2-n) und eine gesonderte Spannungsquelle aufweist, die den Kondensator (C2-n) mit einer Spannung beaufschlagt, wobei der Zusatzstrom (dI) für sämtliche lichtemittierenden Elemente (LED1-n) in identischer Weise jeweils kapazitiv durch die Entladung des jeweiligen Kondensators (C2-n) aufgeprägt ist.

**10.** Hochleistungsschaltmodul nach Anspruch 9, **dadurch gekennzeichnet, dass** die Entladung des Kondensators (C2-n) für sämtliche Schaltstufen durch eine Steuereinrichtung (15) getriggert ist.

**11.** Hochleistungsschaltmodul nach einem der vorangehenden Ansprüche, **dadurch gekennzeichnet, dass** das der Strom im Arbeitspunkt (IA) des lichtemittierenden Elements (LED1-n) in die Mitte eines linearen Bereichs des lichtemittierenden Elementes (LED1-n) gelegt ist.

**12.** Hochleistungsschaltmodul nach einem der vorangehenden Ansprüche, **dadurch gekennzeichnet, dass** das Hochleistungsschaltmodul dazu ausgebildet ist, dass die durch das optische Triggernetzwerk (20) getriggerten Treiberbaugruppen (11) synchron ein Einschalten und Ausschalten der einzelnen Schaltstufen (10) mit Abweichungen lediglich im Pikosekundenbereich realisieren.

**13.** Hochleistungsschaltmodul nach einem der vorangehenden Ansprüche, **dadurch gekennzeichnet, dass** der Halbleiterschalter (TS-n) in Form eines Halbleiter-Dies (31) mit einer planen Oberseite und einer planen Unterseite ausgebildet ist, der an seiner planen Oberseite den Emitter-Anschluss und an seiner planen Unterseite den Kollektor-Anschluss ausbildet oder umgekehrt, wobei

    - die plane Unterseite des Halbleiter-Dies (31) auf einer planen ersten Leitebene (32) angeordnet ist und über die plane erste Leitebene (32) kontaktiert wird,
    - sich unterhalb der planen ersten Leitebene (32) eine plane zweite Leitebene (33) erstreckt,
    - sich zwischen der planen ersten Leitebene (32) und der planen zweiten Leitebene (33) eine Isolationsschicht (34) erstreckt, und
    - sich von der zweiten planen Leitebene (33) eine Kontaktverbindung (37) zur planen Oberseite des Halbleiter-Dies (31) zur Kontaktierung der planen Oberseite erstreckt.

**14.** Hochleistungsschaltmodul nach Anspruch 11, **dadurch gekennzeichnet, dass** die Kontaktverbindung zumindest des Emitteranschlusses des Halbleiterschalters (TS-n) durch mindestens einen Kupferbügel (37) bereitgestellt wird, der sich von der zweiten planen Leitebene (33) zur planen Oberseite des Halbleiter-Dies (31) erstreckt.

**Claims**

**1.** High-power switching module for the direct high-precision pulse energy feeding of a consumer with a plurality of switching stages (10) connected in series, each switching stage (10) having:

    - a semiconductor switch (TS-n) with collector terminal (C), emitter terminal (E) and control terminal (G), which depending on the voltage present at the control terminal (G) has a switched-on state, in which a current flows between the collector terminal (C) and the emitter terminal (E), and a switched-off state, in which no current flows between the collector terminal (C) and the emitter terminal (E),
    - a driver assembly (11) acting on the semiconductor switch (TS-n), the driver assembly (11) having two switches (Tl-n, T2-n) for controlling the control terminal (G) of the semiconductor switch (TS-n) and also an energy store (CT-n), which provides energy for switching on the semiconductor switch (TS-n),
- an optical trigger network (20), which is optically coupled to the driver assemblies (11) of the individual switching stages (10) in order to simultaneously switch the switching stages (10), the optical trigger network (20) having a plurality of light emitting elements (LED1-n) switchable simultaneously between a low emitted luminous flux and a high emitted luminous flux, and each light emitting element (LED1-n) of the optical trigger network (20) being assigned at least one light detecting element (LD1-n) of a switching stage (10), the at least one light detecting element (LD1-n) initiating a change in the switching state of the switching stage (10) depending on whether said element receives a low luminous flux or a high luminous flux.

**characterized in that**
the light emitting elements (LED1-n) are set stage-individually to a current at the operating point (IA) at which the light emitting element (LED1-n) emits a luminous flux, a positive or negative additional current (dl) being impressed on the current at the operating point (IA) for switching over to a high luminous flux or a low luminous flux.

2. High-power switching module according to Claim 1, **characterized in that** the light emitting elements (LED1-n) and/or the light detecting elements (LD1-n) are set stage-individually by means of assigned setting means in such a way that, in the state in which the light emitting element (LED1-n) emits a low luminous flux, the assigned light detecting element (LD1-n) is at the threshold for detecting a high luminous flux.

3. High-power switching module according to Claim 1 or 2, **characterized in that** the optical network (20) for each switching stage (10) controls the state of the two switches (Tl-n, T2-n) which operate complementarily in the sense that one switch (T1-n) is open when the other switch (T2-n) is closed, and vice versa, and the two switching states define the switched-on state and the switched-off state of the semiconductor switch (TS-n), the two switches (Tl-n, T2-n) being switched by the output voltage of a comparator (OP1-n) and the optical network (20) for each switching stage (10) controlling the comparator (OP1-n) by means of the luminous flux detected by the light detecting element (LD1-n).

4. High-power switching module according to one of the preceding claims, **characterized in that** the high-power module for each switching stage (10) furthermore comprises a comparator (35) having two inputs, at least one of the inputs being supplied with the varying voltage of the light detecting element (LD1-n) of the switching stage (10), and, depending on whether the light detecting element (LD1-n) of the switching stage (10) receives a low luminous flux or a high luminous flux, the output of the comparator (35) providing a positive voltage or a negative voltage which is applied to supply lines (351, 352) of the comparator (35), the output voltage of the comparator (35) controlling the switches (Tl-n, T2-n) of the respective driver assembly (11).

5. High-power switching module according to Claim 4, **characterized in that** the comparator (35) has two inputs, one input being supplied with the variable voltage of the light detecting element (LD1-n) of the switching stage (10) and the other input having a reference voltage applied thereto.

6. High-power switching module according to Claim 4, **characterized in that** the comparator (35) has two inputs, one input being supplied with the variable voltage of the light detecting element (LD1-n) of the switching stage (10) by way of a resistor (R2-n) and the other input being supplied with the variable voltage of the light detecting element (LD1-n) of the switching stage (10) by way of an RC element (R1-n, C1-n), a change in the voltage of the light detecting element (LD1-n) being supplied to the inputs of the comparator (35) with a different inertia.

7. High-power switching module according to one of Claims 4 to 6, **characterized in that** the comparator is in the form of an operational amplifier.

8. High-power switching module according to one of the preceding claims, **characterized in that**, for each switching stage (10) the light detecting element (LD1-n) is connected in series with a resistor (RA-n) which sets the operating point of the light detecting element (LD1-n) .

9. High-power switching module according to one of the preceding claims, **characterized in that** the optical trigger network (20) has for each switching stage a capacitor (C2-n) and a separate voltage source which applies a voltage to the capacitor (C2-n), the additional current (dl) is impressed in each case capacitively by the discharge of the respective capacitor (C2-n) for all of the light emitting elements (LED1-n) in an identical way.

10. High-power switching module according to Claim 9, **characterized in that** the discharge of the capacitor (C2-n) is triggered by a control device (15) for all of the switching stages.

11. High-power switching module according to one of the preceding claims, **characterized in that** the current at the operating point (IA) of the light emitting element (LED1-n) is positioned in the centre of a linear range of the light emitting element (LED1-n).

12. High-power switching module according to one of the preceding claims, **characterized in that** the high-power switching module is designed so that the driver assemblies (11) triggered by the optical trigger network (20) implement switch-on and switch-off of the individual switching stages (10) synchronously with deviations only in the picosecond range.

13. High-power switching module according to one of the preceding claims, **characterized in that** the semiconductor switch (TS-n) is in the form of a semiconductor die (31) with a planar top side and a planar underside, which embodies the emitter terminal at its planar top side and the collector terminal at its planar underside, or vice versa,

- the planar underside of the semiconductor die (31) being arranged on a planar first conductive plane (32) and being contacted via the planar first conductive plane (32),
- a planar second conductive plane (33) extending below the planar first conductive plane (32),
- an insulation layer (34) extending between the planar first conductive plane (32) and the planar second conductive plane (33), and
- from the second planar conductive plane (33) a contact connection (37) extending to the planar top side of the semiconductor die (31) for the contacting of the planar top side.

14. High-power switching module according to Claim 11, **characterized in that** the contact connection of at least the emitter terminal of the semiconductor switch (TS-n) is provided by at least one copper clip (37) extending from the second planar conductive plane (33) to the planar top side of the semiconductor die (31).

## Revendications

1. Module de commutation à haute performance destiné à l'alimentation en énergie pulsée, directe et de haute précision, d'un consommateur, comprenant une pluralité d'étages de commutation (10) montés en série, chaque étage de commutation (10) présentant :

- un commutateur à semi-conducteur (TS-n) pourvu d'une borne de collecteur (C), d'une borne d'émetteur (E) et d'une borne de commande (G) qui présente, en fonction de la tension appliquée à la borne de commande (G), un état connecté dans lequel un courant circule entre la borne de collecteur (C) et la borne d'émetteur (E), et un état déconnecté dans lequel aucun courant ne circule entre la borne de collecteur (C) et la borne d'émetteur (E),
- un ensemble d'attaque (11) qui agit sur le commutateur à semi-conducteur (TS-n), l'ensemble d'attaque (11) présentant deux commutateurs (TI-n, T2-n) destinés à commander la borne de commande (G) du commutateur à semi-conducteur (TS-n) ainsi qu'un accumulateur d'énergie (CT-n) qui fournit de l'énergie pour la connexion du commutateur à semi-conducteur (TS-n),
- un réseau de déclenchement optique (20) qui est couplé optiquement aux ensembles d'attaque (11) des étages de commutation individuels (10) afin de commuter les étages de commutation (10) simultanément, le réseau de déclenchement optique (20) présentant une pluralité d'éléments électroluminescents (LED1-n) qui peuvent être commutés simultanément entre un flux lumineux émis faible et un flux lumineux émis fort, et chaque élément électroluminescent (LED1-n) du réseau de déclenchement optique (20) étant associé à au moins un élément de détection de lumière (LD1-n) d'un étage de commutation (10), ledit au moins un élément de détection de lumière (LD1-n) déclenchant un changement de l'état de commutation de l'étage de commutation (10) selon qu'il reçoit un flux lumineux faible ou un flux lumineux élevé,

**caractérisé en ce que** les éléments électroluminescents (LED1-n) sont réglés individuellement par étage sur un courant au point de fonctionnement (IA) dans lequel l'élément électroluminescent (LED1-n) émet un flux lumineux, un courant supplémentaire positif ou négatif (dI) étant appliqué au courant au point de fonctionnement (IA) pour une commutation sur un flux lumineux élevé ou un flux lumineux faible.

2. Module de commutation à haute performance selon la revendication 1, **caractérisé en ce que** les éléments électroluminescents (LED1-n) et/ou les éléments de détection de lumière (LD1-n) sont réglés individuellement par étage à l'aide de moyens de réglage associés de sorte qu'à l'état dans lequel l'élément électroluminescent (LED1-n) émet un flux lumineux faible, l'élément de détection de lumière (LD1-n) associé se trouve au seuil de la détection d'un flux lumineux élevé.

3. Module de commutation à haute performance selon la revendication 1 ou 2, **caractérisé en ce que** le réseau optique (20) commande pour chaque étage de commutation (10) l'état des deux commutateurs (Tl-n, T2-n) qui fonctionnent de manière complémentaire **en ce que** ledit un commutateur (T1-n) est ouvert lorsque l'autre commutateur (T2-n) est fermé, et vice versa, et les deux états de commutation définissent l'état connecté et l'état déconnecté du commutateur à semi-conducteur (TS-n), dans lequel les deux commutateurs (T1-n, T2-n) sont commutés par la tension de sortie d'un comparateur (OP1-n), et le réseau optique (20) commande le comparateur (OP1-n) pour chaque étage de commutation (10) par l'intermédiaire du flux lumineux détecté par l'élément de détection de lumière (LD1-n).

4. Module de commutation à haute performance selon l'une quelconque des revendications précédentes, **caractérisé en ce que** le module de commutation à haute performance présente pour chaque étage de commutation (10) de plus un comparateur (35) qui présente deux entrées, dans lequel la tension variable de l'élément de détection de lumière (LD1-n) de l'étage de commutation (10) est amenée à au moins l'une des entrées, et dans lequel, en fonction du fait que l'élément de détection de lumière (LD1-n) de l'étage de commutation (10) reçoit un flux lumineux faible ou un flux lumineux élevé, la sortie du comparateur (35) fournit une tension positive ou une tension négative qui est appliquée à des lignes d'alimentation (351, 352) du comparateur (35), dans lequel la tension de sortie du comparateur (35) commande les commutateurs (T1-n, T2-n) de l'ensemble d'attaque (11).

5. Module de commutation à haute performance selon la revendication 4, **caractérisé en ce que** le comparateur (35) présente deux entrées, dans lequel la tension variable de l'élément de détection de lumière (LD1-n) de l'étage de commutation (10) est amenée à ladite une entrée, et l'autre entrée est alimentée par une tension de référence.

6. Module de commutation à haute performance selon la revendication 4, **caractérisé en ce que** le comparateur (35) présente deux entrées, dans lequel la tension variable de l'élément de détection de lumière (LD1-n) de l'étage de commutation (10) est amenée à ladite une entrée par l'intermédiaire d'une résistance (R2-n), et la tension variable de l'élément de détection de lumière (LD1-n) de l'étage de commutation (10) est amenée à l'autre entrée par l'intermédiaire d'un circuit RC (R1-n, C1-n), dans lequel une variation de tension de l'élément de détection de lumière (LD1-n) est amenée à inertie variable aux entrées du comparateur (35).

7. Module de commutation à haute performance selon l'une quelconque des revendications 4 à 6, **caractérisé en ce que** le comparateur est réalisé sous forme d'amplificateur opérationnel.

8. Module de commutation à haute performance selon l'une quelconque des revendications précédentes, **caractérisé en ce que** pour chaque étage de commutation (10), l'élément de détection de lumière (LD1-n) est connecté en série avec une résistance (RA-n) qui règle de point de fonctionnement de l'élément de détection de lumière (LD1-n).

9. Module de commutation à haute performance selon l'une quelconque des revendications précédentes, **caractérisé en ce que** le réseau de déclenchement optique (20) présente pour chaque étage de commutation un condensateur (C2-n) et une source de tension séparée qui alimente le condensateur (C2-n) en tension, dans lequel le courant supplémentaire (dl) est appliqué de manière identique à tous les éléments électroluminescents (LED1-n), respectivement de manière capacitive par la décharge du condensateur (C2-n) respectif.

10. Module de commutation à haute performance selon la revendication 9, **caractérisé en ce que** la décharge du condensateur (C2-n) est déclenchée pour tous les étages de commutation par un dispositif de commande (15).

11. Module de commutation à haute performance selon l'une quelconque des revendications précédentes, **caractérisé en ce que** le courant au point de fonctionnement (IA) de l'élément électroluminescent (LED1-n) est placé au milieu d'une zone linéaire de l'élément électroluminescent (LED1-n).

12. Module de commutation à haute performance selon l'une quelconque des revendications précédentes, **caractérisé en ce que** le module de commutation à haute performance est réalisé pour que les ensembles d'attaque (11) déclenchés par le réseau de déclenchement optique (20) effectuent de manière synchrone une connexion et une déconnexion des étages de commutation (10) individuels avec des écarts uniquement de l'ordre de la picoseconde.

**13.** Module de commutation à haute performance selon l'une quelconque des revendications précédentes, **caractérisé en ce que** le commutateur à semi-conducteur (TS-n) est réalisé sous la forme d'une puce à semi-conducteur (31) ayant une face supérieure plane et une face inférieure plane, qui réalise sur sa face supérieure plane la borne d'émetteur et réalise sur sa face inférieure plane la borne de collecteur, ou inversement, dans lequel

- la face inférieure plane de la puce à semi-conducteur (31) est disposée sur un premier niveau conducteur plan (32) et est contactée par l'intermédiaire du premier niveau conducteur plan (32),
- un deuxième niveau conducteur plan (33) s'étend sous le premier niveau conducteur plan (32),
- une couche d'isolation (34) s'étend entre le premier niveau conducteur plan (32) et le deuxième niveau conducteur plan (33), et
- une liaison de contact (37) avec la face supérieure plane de la puce à semi-conducteur (31) s'étend à partir du deuxième niveau conducteur plan (33) pour la mise en contact de la face supérieure plane.

**14.** Module de commutation à haute performance selon la revendication 11, **caractérisé en ce que** la liaison de contact au moins de la borne d'émetteur du commutateur à semi-conducteur (TS-n) est fournie par au moins un étrier de cuivre (37) qui s'étend du deuxième niveau conducteur plan (33) à la face supérieure plane de la puce à semi-conducteur (31).

Fig. 1

Fig. 2

Fig. 3

Fig. 4

Fig. 5

Fig. 6

Fig. 6a

Fig. 7

Fig. 8

Fig. 9

Fig. 10

Fig. 11

**IN DER BESCHREIBUNG AUFGEFÜHRTE DOKUMENTE**

**In der Beschreibung aufgeführte Patentdokumente**

- WO 2007134589 A3

- WO 2011095212 A2

**In der Beschreibung aufgeführte Nicht-Patentliteratur**

- **F.W.GROVER.** Inductance calculations: working formulas and tables. Instrument society of America, 1973